# EUROPÄISCHE PATENTSCHRIFT

(11) **EP 0 362 649 B1**
(45) Veröffentlichungstag und Bekanntmachung des Hinweises auf die Patenterteilung: **02.03.1994**
(21) Anmeldenummer: 89117621.6
(22) Anmeldetag: 23.09.1989
(51) Int. Cl.: C08G 73/06, G03F 7/038

(54) **Strahlungsempfindliche Gemische und deren Verwendung**
Radiation-sensitive compositions and their use
Compositions sensibles au rayonnement et leur utilisation

(30) Priorität: 01.10.1988 DE 3833438
(43) Veröffentlichungstag der Anmeldung: 11.04.1990
(73) Patentinhaber: BASF Aktiengesellschaft, 67063 Ludwigshafen (DE)
(72) Erfinder: Blum, Rainer, D-6700 Ludwigshafen (DE); Rehmer, Gerd, Dr., D-6711 Beindersheim (DE); Schupp, Hans, Dr., D-6520 Worms 1 (DE)

(56) Entgegenhaltungen:
- EP-A- 0 027 506
- EP-A- 0 119 719

## Beschreibung

Die Erfindung betrifft strahlungsempfindliche Gemische, die oligomere und/oder polymere, in Gegenwart geeigneter Initiatoren durch Strahlung, vorzugsweise UV-Strahlung, in ihrer Löslichkeit veränderliche Vorstufen von Polyimiden, Polyisoindolochinazolindionen, Polyoxazindionen, Polychinazolindionen, Polychinazolonen und verwandten Polyheterocyclen enthalten, Verfahren zu deren Herstellung und deren Verwendung.

Es ist bekannt, strukturierte Schichten, insbesondere für den Aufbau elektronischer Schaltungen, dadurch zu erzeugen, daß zunächst lösliche, strahlungsempfindliche, bevorzugt UV-empfindliche Vorstufen (A) aus Lösung auf das Substrat aufgetragen und unter milden Bedingungen getrocknet werden. Unter einer Maske wird dann mit Strahlen einer geeigneten Wellenlänge eine entsprechend der Maske strukturierte vernetzte Zwischenstufe (B) gebildet. Mit geeigneten Lösemitteln werden die nicht bestrahlten, d.h. unbelichteten Stellen, die noch die Vorstufe (A) enthalten, ausgewaschen. Die aus den stehengebliebenen Stellen gebildete Struktur wird schließlich unter Anwendung hoher Temperaturen in die Endfunktionsstruktur der Stufe (C) überführt.

Für die Herstellung von Strukturen die, z.B. bei der Herstellung oder dem Gebrauch von Schaltkreisen der Mikroelektronik, hohen thermischen und mechanischen Belastungen ausgesetzt sind, werden als Stoffe der Funktionsstufe (C) bevorzugt die oben erwähnten heterocyclischen bzw. aromatischheterocyclischen Polymeren verwendet.

Die löslichen Vorstufen (A) für solche Polymeren (C) sind im allgemeinen von polyamidischer Grundstruktur und zwar so, daß in Nachbarschaft zur Amidgruppe eine andere Gruppe steht, in der Regel eine Carboxyl-, Ester-oder Ethergruppe, die bei der Überführung in die Stufe (C) unter Anwendung höherer Temperaturen mit der Amidgruppe eine Kondensationsreaktion eingeht.

Es sind zwei Wege bekannt, polyamidische Grundstrukturen der Stufe (A) strahlenvernetzbar zu machen.
1. Die direkte Vernetzung an der Polymergrundkette, wobei vom Benzophenon oder dem Benzophenon strukturähnlichen Carbonylverbindungen ausgegangen wird, die an der Carbonylgruppe, in Gegenwart geeigneter Photoinitiatoren, mit UV-Licht vernetzen. Solche Systeme sind z.B. in EP-A-01 34 752, EP-A-01 81 837, EP-A-01 62 017 und US-A-4 568 601 beschrieben.
   Nachteilig ist, daß nur wenige Benzophenonabkömmlinge für den Aufbau von geeigneten polymeren Vorstufen bekannt und noch weniger technisch verfügbar sind, daß also die Einstellung bestimmter Eigenschaften der Stufe (C), über Variationen des polymeren Aufbau nicht in ausreichendem Maß gegeben ist.
2. Die Vernetzung über Seitenketten mit olefinisch ungesättigten Gruppen und die Herstellung hierfür geeigneter Vorstufen, wie sie z.B. in DE-A-24 37 397, DE-A-24 37 348, DE-A-24 37 413, DE-A-24 37 369, DE-A-29 19 840, DE-A-29 19 841, DE-A-29 33 826 und DE-A-23 08 830 beschrieben wird.
   Vorstufen der genannten Art, die in organischen Lösungsmittel löslich sind, sind beispielsweise in der DE-PS 23 08 830 beschrieben. Diese polymeren Vorstufen sind Polyadditions- oder Polykondensationsprodukte polyfunktioneller carbocyclischer oder heterocyclischer strahlungsempfindliche Reste tragender Verbindungen mit Diaminen, Diisocyanaten, Bis-säurechloriden oder Dicarbonsäuren. Die strahlungsempfindliche Reste tragenden Verbindungen enthalten zwei für Additions- oder Kondensationsreaktionen geeignete Carboxyl-, Carbonsäurechlorid-, Amino-, Isocyanat- oder Hydroxylgruppen und teilweise in ortho- oder para-Stellung dazu esterartig an Carboxylgruppen gebundene ethylenisch ungesättigten Gruppen. Die mit diesen Verbindungen umzusetzenden Diamine, Diisocyanate, Bis-säurechloride und Dicarbonsäuren weisen mindestens ein cyclisches Strukturelement auf.
   Strahlungsreaktive Polyimid-Vorstufen werden dabei insbesondere in der Weise hergestellt, daß ungesättigte Alkohole, wie Allylalkohol, an Tetracarbonsäuredianhydride, wie Pyromellithsäuredianhydrid, addiert, die freien Carbonsäuregruppen der dabei gebildeten Diester in Säurechloridgruppen übergeführt und die entstandenen Diester-bis-säurechloride einer Polykondensationsreaktion mit einem- meist aromatischen- Diamin, wie Diaminodiphenyläther, unterworfen werden. Bei der Verwendung von Diaminoverbindungen, die ortho-ständige Amidogruppen aufweisen, entstehen in entsprechender Weise Polyisoindolochinazolindione.
   Polyoxazindion-Vorstufen entstehen durch Polyaddition von Diisocyanaten, wie Diphenylmethandiisocyanat, an phenolische Hydroxylgruppen olefinisch ungesättigter Diester, wie Methylen-disalicylsäureester, und - in entsprechender Weise - Polychinazolindione durch Polyaddition von Diisocyanaten an Aminogruppen olefinisch ungesättigter Diester.
   Die bekannten Herstellungsverfahren erfordern im allgemeinen mehrere Reaktionsschritte und auch tiefe Temperaturen. Darüber hinaus ist bei der Verwendung von Säurechloriden eine intensive Reinigung der Reaktionsprodukte erforderlich, d.h. die Synthese von ungesättigten Diestern der genannten Art ist schwierig durchzuführen.
   In DE-A-2 933 826 wird ein Weg aufgezeigt, durch Addition von ungesättigten Epoxiden an carboxylgruppentragende Vorstufen, einen Teil dieser Schwierigkeiten zu umgehen. Nachteilig ist dabei, daß Carboxylgruppen nur bei höherer Temperatur und mit Katalysatoren in befriedigender Geschwindigkeit mit Epoxidgruppen reagieren. Dies führt dazu, daß häufig unlösliche, z.B. durch Teilimidisierung, oder anvernetzte Produkte entstehen.
   Nachteile dieses Prinzips sind also die Schwierigkeiten beim Aufbau der Stufen (A), die sich aus dem ungesättigten Charakter der Ausgangs- und der Endstoffe ergeben.
   Es dürfen z.B. nur relativ niedrige Temperaturen angewandt werden, was lange Reaktionszeiten und schlechte Umsätze ergibt. Weiter müssen trotzdem z.T. Polymerisationsinhibitoren bei der Herstellung zugegeben und später in aufwendigen Reinigungsschritten wieder entfernt werden, um bei der Verwendung eine hohe Lichtempfindlichkeit zu erreichen.
   Ein anderer Nachteil ergibt sich bei der Aufbewahrung und Verarbeitung der ungesättigten Stufen (A), die wegen der Gefahren der Oxidation und Polymerisation, unter Inertgas und Kühlung erfolgen müssen.

Aufgabe der vorliegenden Erfindung ist es, solche oligomere und/oder polymere Vorstufen von Polyimiden, Polyisoindolochinazolindionen, Polyoxazindionen, Polychinazolindionen, Polychinazolonen und verwandten Polyheterocyclen bereitzustellen, die in organischen Lösemitteln löslich, strahlungsreaktiv, in einfacher Weise herstellbar und ohne besondere Vorsichtsmaßnahmen, wie Inertgas und Kühlung, aufbewahrbar und verarbeitbar sind.

Diese Aufgabe läßt sich überraschenderweise erfindungsgemäß durch Einführung leicht abstrahierbarer Wasserstoffe in die Polymerhauptkette der Vorstufen (a) sowie Mitverwendung bestimmter Carbonylverbindungen lösen.

Gegenstand der vorliegenden Erfindung sind strahlungsempfindliche, zur Herstellung von Polyimiden, Polyisoindolochinazolindionen, Polyoxazindionen, Polychinazolindionen oder Polychinazolonen geeignete Gemische, die bei Bestrahlung mit aktinischem Licht eine Löslichkeitsdifferenzierung erfahren, die dadurch gekennzeichnet sind, daß die strahlungsempfindlichen Gemische bestehen aus
(a) einer oder mehreren Vorstufen, die Strukturelemente der allgemeinen Formel (I) aufweisen, 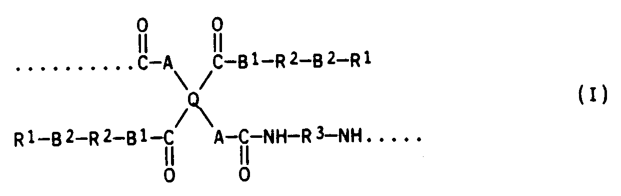 worin
   - A =: -O-, -NH- oder eine Einfachbindung,
   - Q =: ein gegebenenfalls aromatischer oder heterocyclischer tetravalenter Rest, oder ein zwei über eine Brückengruppe miteinander verbundene bivalente aromatische Reste enthaltender Rest, in dem jeweils zwei der Valenzen in Nachbarstellung zueinander angeordnet sind,
   - B¹ =: -O- oder -NR⁴-,
   - B² =: -NH-CO-NH-, -NH-CO-O-, -NH-CO- oder eine Einfachbindung,
   - R¹ =: H, Alkyl, Aryl, ein ethylenisch ungesättigter Rest oder ein leicht wasserstoffabgebender Rest aus der Gruppe Isoalkyle, Aminoisoalkyle, Cycloisoalkyle, Cycloisoalkyle mit einem oder mehreren Heteroatomen, Isoalkylaryle oder Gruppierungen folgender allgemeiner Formeln ausgewählt ist 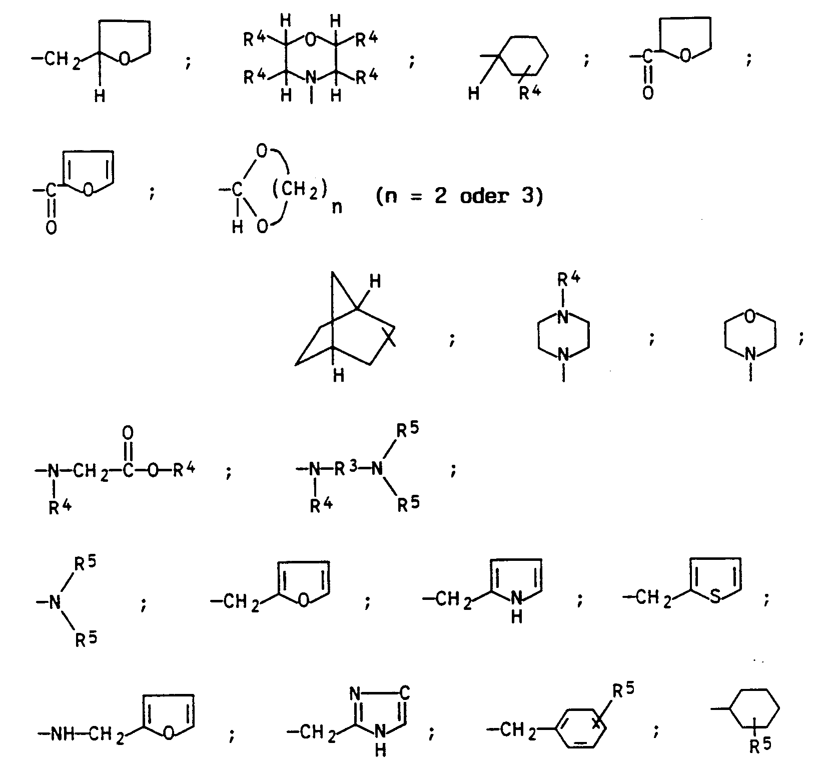
   worin
   - n =: 2 oder 3 und
   - R² =: ein bivalenter aliphatischer oder aromatischer Rest oder eine Einfachbindung,
   - R³ =: ein bivalenter aliphatischer, cycloaliphatischer, aromatischer oder heterocyclischer Rest, der gegebenenfalls halogensubstituiert ist, oder eine Einfachbindung,
   - R⁴ =: H, geradkettiges oder verzweigtes Alkyl, das halogensubstituiert sein kann, und
   - R⁵ =: Alkyl, Aryl, halogensubstituiertes Alkyl, halogensubstituiertes Aryl oder Isoamylphenyl,
   mit der Maßgabe, daß mindestens einer der Reste Q und R³ ein Isoalkyl-, Methylcyclohexyl-, Amino-isoalkyl-, Furfuryl-, Tetrahydrofurfuryl-, Benzyl-, Cumyl-, p-Menthyl-, Terpin- und/oder Thymolylrest ist.
(b) einer oder mehreren aromatische Reste enthaltenden Carbonylverbindungen, die im durch UV-Strahlung angeregten Zustand zur Wasserstoffabstraktion befähigt sind, gegebenenfalls zusätzlich aliphatische Ketone und Copolymerisate von Kohlenmonoxid mit Ethylen allein oder in Kombination mit den oben genannten Carbonylverbindungen, sowie gegebenenfalls
(c) einem oder mehreren Stoffen aus der Gruppe Photoinitiator, Photosensibilisator, (Leuko)Farbstoff und aliphatisches Keton, wobei zur Prüfung der Strahlungsempfindlichkeit dieser Gemische, deren Harzlösungen mit 2 % Benzophenon, bezogen auf den Harzgehalt, auf Glasplatten aufgerakelt, bei 50°C im Vakuum 3 Stunden getrocknet, die so erhaltenen 25 bis 30 µm dicken klebfreien Filme zur Hälfte mit Aluminiumfolie abgedeckt, unter einer Quecksilberhochdrucklampe 15 Minuten belichtet und dann durch Reiben mit einem mit einer Mischung aus Ethanol/N-Methylpyrrolidon 1:1 getränkten Wattebausch auf Unterschiede der Löslichkeit zwischen bestrahlten und abgedeckten Stellen geprüft werden.

Q ist also ein - gegebenenfalls halogenierter - zumindest partiell aromatischer und/oder heterocyclischer tetravalenter Rest, bei dem jeweils zwei Valenzen in Nachbarstellung zueinander angeordnet sind. Weist der Rest Q mehrere aromatische und/oder heterocyclische Strukturelemente auf, so befinden sich die Valenzpaare jeweils an endständigen derartigen Strukturelementen.

Q und/oder R³ besitzen in der Molekülhauptkette mindestens ein leicht abstrahierbares Wasserstoffatom.

R¹ und/oder R² und/oder R³ und/oder Q können direkt am Molekül oder aber auch über Bindeglieder z.B. über Ester-, Ether-, Amid-, Amino- oder Urethangruppen gebunden, weitere leicht abstrahierbare Wasserstoffatome besitzen.

Als aromatische Reste enthaltende Carbonylverbindung (b) kommen insbesondere solche aus der Gruppe Benzophenon, Xanthon, Thioxanthon, Fluorenon, Benzil, Acenaphthenchinon, Tetralon, Benzylidenaceton, Dibenzylidenaceton, Benzoin, Benzoinether, Benzanilid, Acetophenon, Propiophenon, Naphthochinon, Anthrachinon, Anthron und die aus diesen Grundkörpern, z.B. durch Halogenierung oder Alkylierung, abgeleiteten Carbonylverbindungen in Frage.

Ebenso können als Carbonylverbindung (b) Benzophenon und Benzophenonderivate, allein oder im Gemisch mit 2-, 3- und 4-Hydroxibenzophenon, Benzophenon-2-carbonsäure, Benzophenon-3-carbonsäure, Benzophenon-4-carbonsäure, 3,3',4,4'-Benzophenontetracarbonsäure und deren Anhydrid, 3,3',4,4'-Tetra-(tert.-butylperoxycarbonyl)-benzophenon, 2-, 3- und 4-Phenylbenzophenon, 2-, 3- und 4-Alkylbenzophenone mit 1 bis 10 C-Atomen im Alkylrest oder halogenierten (Monoalkyl)benzophenonen, wie 4-(Trifluormethyl)-benzophenon sowie Heterocerdianthron und dessen Endoperoxid, oder Ketone wie 2-Acetonaphthon, 4-Aminobenzophenon, 4,4'-Tetramethylaminobenzophenon und die Salze dieser Amine sowie gegebenenfalls auch zusätzlich aliphatische Ketone wie Aceton, Methylisobutylketon, Isoamylketon und Copolymerisate von Kohlenmonoxid mit Ethylen allein oder in Kombination mit den obengenannten Carbonylverbindungen eingesetzt werden.

Die erfindungsgemäßen strahlungsempfindlichen Gemische enthalten die Carbonylverbindung (b) im allgemeinen in einer Menge von 0,001 bis 200, vorzugsweise 1 bis 20 Gew.%, bezogen auf die Vorstufe (a).

In den erfindungsgemäßen strahlungsempfindlichen Gemischen können die Carbonylverbindungen (b) in fester, gelöster, dispergierter oder geschmolzener, monomerer und/oder polymerer Form eingesetzt werden; ferner können zur Verbesserung der Lichtempfindlichkeit bzw. zur Anpassung der Absorption an eine UV-Strahlenquelle zusätzlich nichtcarbonylische Photoinitiatoren und/oder bestimmte Farbstoffe zugegeben werden.

Zum Aufbau der Vorstufen (a), die in monomerer, oligomerer oder polymerer Form oder in Mischungen verschiedener Polymerisationsstufen eingesetzt werden können, können carboxylgruppenhaltige Polyadditionsprodukte aus aromatischen und/oder heterocyclischen Tetracarbonsäureanhydriden und Diaminoverbindungen an den Carboxylgruppen mit Resten R¹ über eine Ester-, Ether-, Amid- oder Urethangruppe verknüpft sein oder carboxylgruppenhaltige Polyadditionsprodukte aus aromatischen und/oder heterocyclischen Dihydroxydicarbonsäure und Diisocyanaten können an den Carboxylgruppen mit Resten R¹ über eine Ester-, Ether-, Amid- oder Urethangruppe verknüpft sein, oder carboxylgruppenhaltige Polyadditionsprodukte aus aromatischen und/oder heterocyclischen Diaminodicarbonsäuren und Diisocyanaten können an den Carboxylgruppen mit Resten R¹ über eine Ester-, Ether-, Amid- oder Urethangruppe verknüpft sein.

Gegenstand der vorliegenden Erfindung ist auch ein Verfahren zur Herstellung von erfindungsgemäßen strahlungsempfindlichen Gemischen, wobei zur Einführung der Reste R¹ in die Vorstufen (a), carboxylgruppenhaltige Polyadditionsprodukte aus aromatischen und/oder heterocyclischen Diaminodicarbonsäuren und Diisocyanaten und/oder carboxylgruppenhaltige Polyadditionsprodukte aus aromatischen und/oder heterocyclischen Dihydroxydicarbonsäuren und Diisocyanaten und/oder carboxylgruppenhaltige Polyadditionsprodukte aus aromatischen und/oder heterocyclischen Tetracarbonsäureanhydriden und Diaminoverbindungen mit Monoaddukten von Diisocyanaten mit Verbindungen der Struktur R¹-OH, R¹-NH₂, R¹-(B²)-NH₂, R¹-COOH umgesetzt werden.

Bevorzugt ist, zur Herstellung der Vorstufen (a) in die carboxylgruppenhaltigen Polyadditionsprodukte aus aromatischen und/oder heterocyclischen Diaminodicarbonsäuren und Diisocyanaten und/oder carboxylgruppenhaltigen Polyadditionsprodukte aus aromatischen und/oder heterocyclischen Dihydroxydicarbonsäuren und Diisocyanaten und/oder carboxylgruppenhaltigen Polyadditionsprodukte aus aromatischen und/oder heterocyclischen Tetracarbonsäureanhydriden und Diaminoverbindungen, die Reste R¹ in einer solchen Menge einzuführen, daß das Verhältnis der Reste R¹ zu den Carboxylgruppen der carboxylgruppenhaltigen Polyadditionsprodukte 1:1 bis 0,05 bis 1 beträgt.

Dabei werden vorzugsweise als Tetracarbonsäureanhydrid Pyromellithsäureanhydrid und/oder Benzophenontetracarbonsäureanhydrid, als Dihydroxidicarbonsäure 4,4'-Dihydroxydiphenylmethan-3,3'-dicarbonsäure und als Diaminodicarbonsäure 4,4'-Diaminodiphenylmethan-3,3'-dicarbonsäure eingesetzt.

Die erfindungsgemäßen strahlungsempfindlichen Gemische können zusätzlich zu den darin enthaltenen, über Reste R¹ vernetzbaren Gruppierungen weitere strahlungsempfindliche Reste enthalten, insbesondere Reste mit ethylenischen Doppelbindungen und/oder andere Reste, die mit Bisaziden vernetzen.

Die erfindungsgemäßen strahlungsempfindlichen Gemische können auch mit anderen strahlungsempfindlichen Stoffen und/oder nicht strahlungsempfindlichen Stoffen gemischt, verwendet werden.

Gegenstand der Erfindung ist auch die Verwendung der erfindungsgemäßen strahlungsempfindlichen Gemische zur Erzeugung schützender und isolierender Schichten für die Anwendung beim Aufbau gedruckter Schaltungen und integrierter Schaltkreise, wobei sie einer Strahlenvernetzung und/oder thermischen Nachbehandlung unterzogen werden, oder wobei sie unter einer Maske belichtet und dadurch partiell strahlenvernetzt, danach mit geeigneten Lösemitteln strukturiert und dann gegebenenfalls einer thermischen Nachbehandlung unterzogen werden.

Die erfindungsgemäßen Vorstufen (a) sind in organischen, insbesondere polaren Lösungsmitteln, wie z.B. Formamid, Acetamid, N-Metnylformamid, N,N-Dimethylformamid, N-Methylpyrrolidon, N,N-Dimethylacetamid, Butyrolakton, Caprolactam, Hexamethylphosphorsäuretrisamid oder deren Gemischen, löslich, einfach herstellbar und ohne Anwendung besonderer Vorsichtsmaßnahmen aufzubewahren und zu verarbeiten, ohne an Strahlungsreaktivität zu verlieren.

Die erfindungsgemäßen strahlungsempfindlichen Gemische, d.h. die Mischung der Vorstufen (a) mit den oben genannten Carbonylverbindungen (b), die im durch UV-Strahlung angeregten Zustand zur Wasserstoffabstraktion befähigt sind, zeichnen sich besonders durch geringe Masseverluste bei der Ausbildung der Endfunktionsstrukturen (c) und dadurch bedingter guter Abbildung von Strukturen bei der Anwendung in der Mikroelektronik aus.

Zu den Aufbaukomponenten der erfindungsgemäß einzusetzenden Vorstufen (a) und der strahlungsempfindlichen Gemische ist im einzelnen folgendes auszuführen.

Die erfindungsgemäßen Vorstufen (a) enthalten oder bestehen vorzugsweise aus Gruppierungen der allgemeinen Formel (I) 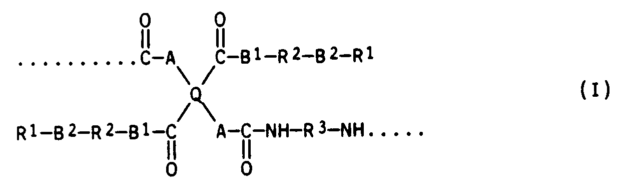
worin
- A =: -O-, -NH- oder eine Einfachbindung,
- Q =: ein, gegebenenfalls halogenierter, aromatischer und/oder heterocyclischer tetravalenter, d.h. tetrafunktioneller Rest, bei dem jeweils zwei Valenzen in Nachbarstellung zueinander angeordnet sind, oder ein zwei über eine Brückengruppe Y (vgl. unten) miteinander verbundene bivalente aromatische Reste enthaltender Rest, d.h. ein insgesamt tetravalenter Rest, bei dem jeweils zwei Valenzen in Nachbarstellung zueinander angeordnet sind; weist der Rest Q mehrere aromatische und/oder heterocyclische Strukturelemente auf, so befinden sich die Valenzpaare jeweils an endständigen derartigen Strukturelementen mit mindestens einem leicht abstrahierbaren Wasserstoffatom, sofern dieses nicht in R³ enthalten ist, wie z.B. 4,4′-Isopropylidendiphthalsäure, Dicarboxydihydroxydiphenylisopropyliden, Tetrahydrofurantetracarbonsäure, Merkaptoantracentetracarbonsäure, 9,10-Dimerkaptoantracendicarbonsäure oder Diisopropyldicarboxydiphenylmethan.
- B¹ =: -O- oder -NR⁴-
- B² =: -NH-CO-NH-, -NH-CO-O-, -NH-CO- oder eine Einfachbindung,
- R² =: ein bivalenter aliphatischer oder aromatischer Rest oder eine Einfachbindung,
R² kann auch ein leicht abstrahierbares Wasserstoffatom enthalten;
- R³ =: ein bivalenter aliphatischer, cycloaliphatischer, aromatischer oder heterocyclischer Rest, der gegebenenfalls auch halogensubstituiert sein kann, und sich vorzugsweise von Diaminen und Diisocyanaten ableitet, die im folgenden noch näher beschrieben sind,
oder eine Einfachbindung,
R³ kann ein leicht abstrahierbares Wasserstoffatom enthalten; er muß letzteres enthalten, wenn Q kein leicht abstrahierbares Wasserstoffatom enthält;
- R¹ =: H, Alkyl mit 1 bis 10 Kohlenstoffatomen, wie z.B. Isopropyl, Aryl, wie z.B. Cumyl, Benzyl, ein ethylenisch ungesättigter Rest, z.B. Allyl, Acryl, Methacryl oder ein leicht wasserstoffabgebender Rest aus der Gruppe: Isoalkyle, mit 3 bis 12 Kohlenstoffatomen, wie z.B. Isopropyl, Isobutyl oder Ethylhexyl, Aminoisoalkyle mit 3 bis 12 Kohlenstoffatomen, wie z.B. Diisopropylaminoethyl, Isopropylaminoalkyl, N-Isobutyl-isopropyl-aminoalkyl, Cycloisoalkyle mit 5 bis 8 Kohlenstoffatomen, beispielsweise Methylcyclohexyl oder Isopropylcyclohexyl, ein oder mehrere Heteroatome enthaltende Cycloisoalkyle, wie z.B. Furfuryl-, Tetrahydrofurfuryl-, p-Menthyl-, Terpin-, Thymolreste, oder Gruppierungen folgender Formeln

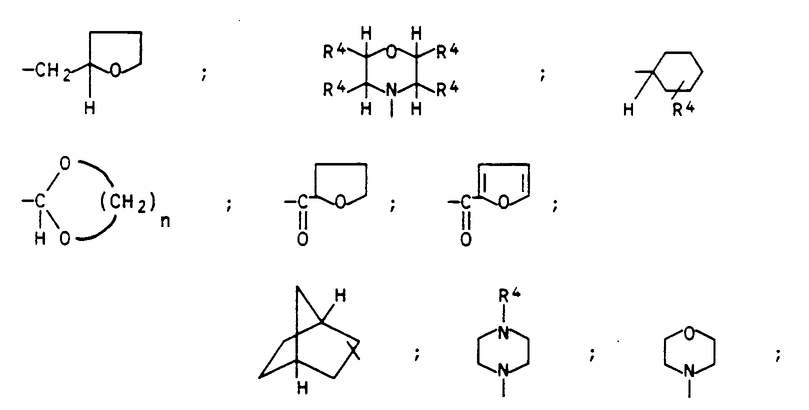

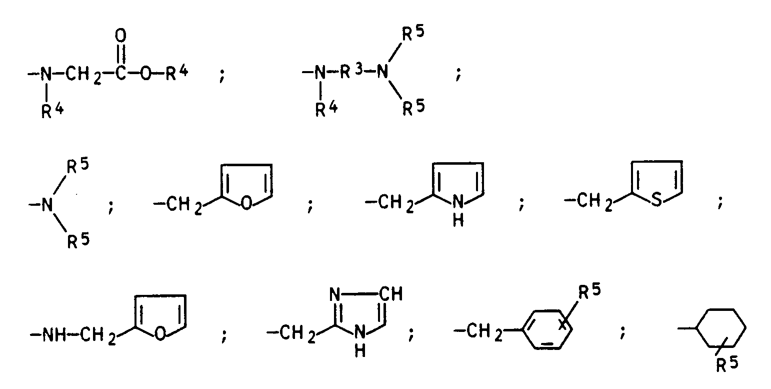

worin
- n =: 2 oder 3
und
- R⁴ =: H, geradkettiges Alkyl mit 1 bis 15 Kohlenstoffatomen, verzweigtes Alkyl mit 1 bis 15 Kohlenstoffatomen, durch Halogen, wie z.B. Cl, F, Br substituiertes geradkettiges oder verzweigtes Alkyl, wie z.B. -C-(CF₃) oder Isopropyl,
- R⁵ =: Alkyl mit 1 bis 15 Kohlenstoffatomen, wie z.B. Isopropyl, Isobutyl oder Isoamyl, Aryl, wie z.B. Isoamylphenyl, durch Halogen, wie z.B. F, Cl oder Br, substituiertes Alkyl mit 1 bis 15 Kohlenstoffatomen, durch Halogen, wie z.B. F, Cl, Br substituiertes Aryl.

### Beispiele für Vorstufen (a) der allgemeinen Formel (I) sind:

### Formel (I/1)

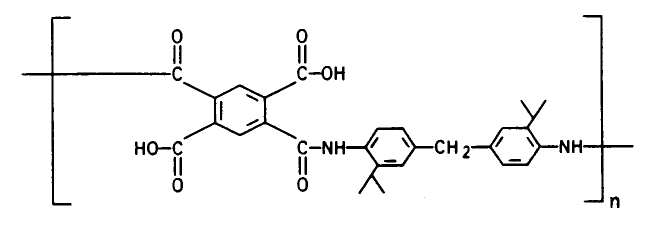

- Q:: Pyromellitsäurerest,
- R³:: 4,4′-Methylen-bis-(2,6-diisopropylanilin)rest mit abstrahierbaren Wasserstoffatomen
- B¹: -O-
- R²:: Einfachbindung
- B²:: Einfachbindung
- R¹:: H
- A:: Einfachbindung,
- n:: 2 bis ca. 200

### Formel (I/2)

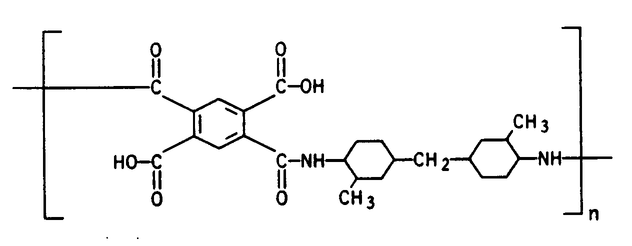

- Q:: Pyromellitsäurerest,
- R³:: [4,4′-Diamino-(3,3-dimethyl)-biscyclohexyl]-methanrest, der erfindungsgemäß leicht abstrahierbare Wasserstoffatome trägt,
- B¹:: -O-,
- R²:: Einfachbindung
- B²:: Einfachbindung
- R¹:: H
- A:: Einfachbindung,
- n:: 2 bis ca. 200

### Formel (I/3)

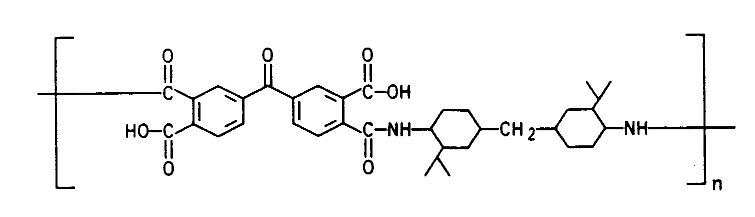

- Q:: Benzophenontetracarbonsäurerest,
- R³:: [4,4′-Diamino-(3,3′-diisopropyl)-biscyclohexyl]-methanrest, der leicht abstrahierbare Wasserstoffatome trägt,
- B¹:: -O-,
- R²:: Einfachbindung,
- B²:: Einfachbindung,
- R¹:: H,
- A:: Einfachbindung,
- n:: 2 bis ca. 200

### Formel (I/4)

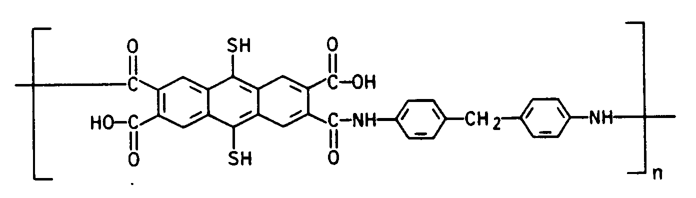

- Q:: 9,10-Dimerkaptoanthracentetracarbonsäurerest, der leicht abstrahierbare Wasserstoffatome trägt,
- R³:: Diaminodiphenylmethanrest,
- B¹:: -O-,
- R²:: Einfachbindung,
- B²:: Einfachbindung,
- R¹:: H,
- A:: Einfachbindung,
- n:: 2 bis ca. 200

Vorstufen (a) der Formeln (I/1) bis (I/4) führen bei Behandlung mit höheren Temperaturen, im allgemeinen > 150°C, zu Polyimiden als Stoffe der Stufe (C).

### Formel (I/5)

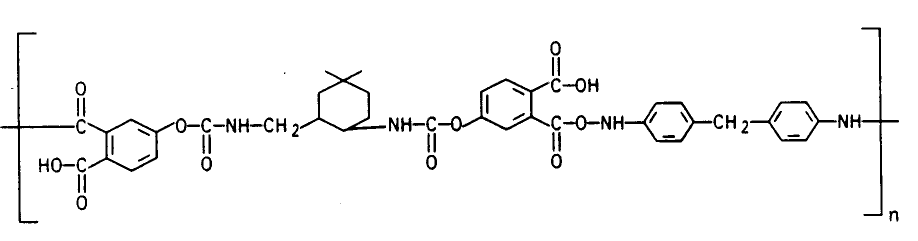

- Q:: Trimellitsäure/Isophorondiisocyanat-Umsetzungsprodukt, das leicht abstrahierbare Wasserstoffatome trägt,
- R³:: Diisocyanatodiphenylmethanrest,
- B¹:: Einfachbindung,
- R²:: Einfachbindung,
- B²:: Einfachbindung,
- R¹:: H,
- A:: Einfachbindung,
- n:: 2 bis ca. 200

Vorstufen (a) der Formel (I/5) führen bei der Behandlung mit höheren Temperaturen, im allgemeinen ≧150°C zu Polyimiden als Stoffe der Stufe (C).

### Formel (I/6)

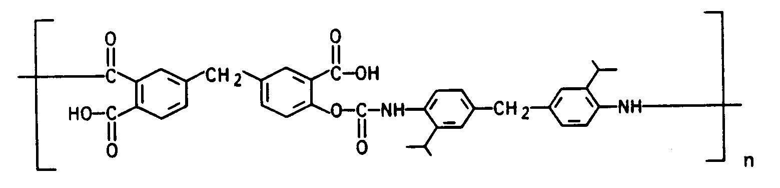

- Q:: 3,3′-Dicarboxyl-4,4′-dihydroxydiphenylmethanrest,
- R³:: 4,4′-Diisocyanato-(3,3′-diisopropyl)-diphenylmethanrest, der erfindungsgemäß leicht abstrahierbare Wasserstoffatome trägt,
- B¹:: Einfachbindung,
- R²:: Einfachbindung,
- B²:: Einfachbindung,
- R¹:: H,
- A:: -O-
- n:: 2 bis ca. 200

Vorstufen (a) der Formel (I/6) bilden bei Behandlung mit höheren Temperaturen in der Regel ≧150°C, Polybenzoxazindione als Stoffe der Stufe (C).

Für den tetravalenten Rest Q in der allgemeinen Formel (I) kommen beispielsweise folgende Reste in Frage, ohne die beanspruchten Strukturen auf solche mit diesen Strukturgliedern zu beschränken.
- Q =: 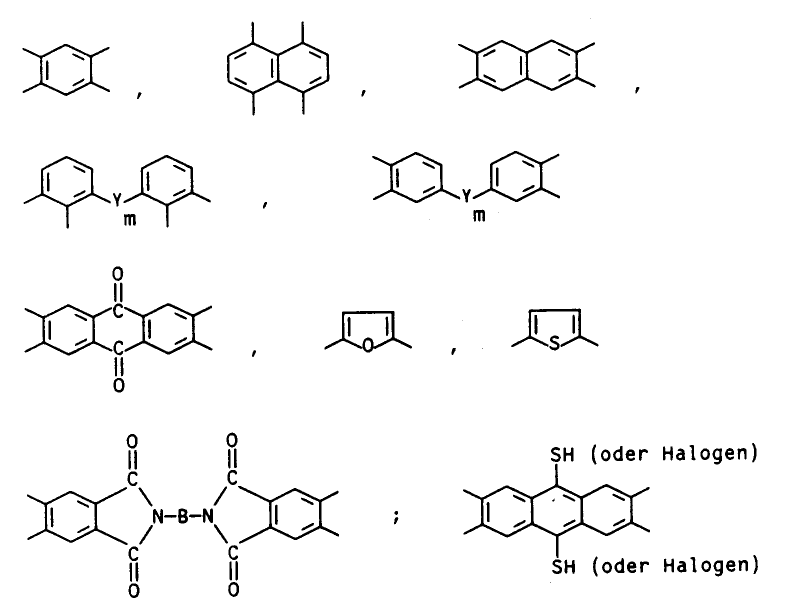
worin:
- Y =: -O- , 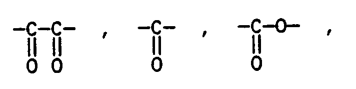 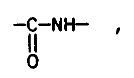 -S- , -SO- , -SO₂- , -CH₂- , -N=N- , 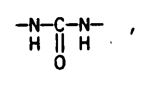 -SO₂-NH- , -NH- , 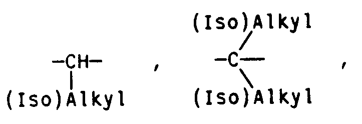 -C=N- ,
- m =: 0 oder 1;
- (Iso)Alkyl =: n-Alkyl mit jeweils 1 bis 10 Kohlenstoffatomen bzw. Isoalkyl mit 3 bis 12 Kohlenstoffatomen,
- B =: 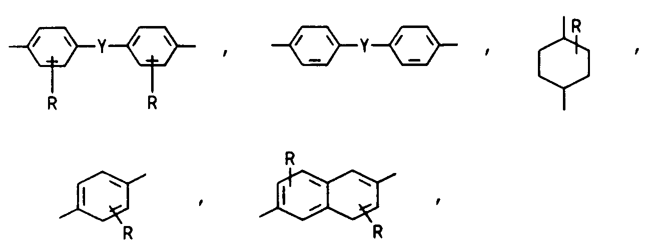
- R =: Alkyl mit 1 bis 10 Kohlenstoffatomen, Isoalkyl mit 1 bis 10 Kohlenstoffatomen, Halogen oder H
sein können.

Vorstufen nach dem Stand der Technik werden dadurch erhalten, daß in diese Doppelbindungen, Gruppen die über Bisacide mit Strahlen vernetzbar sind oder Benzophenongruppen eingebaut und diese Produkte in Gegenwart geeigneter Photoinitiatoren verwendet werden.

Grundsätzlich lassen sich zwei Wege zum Aufbau von Vorstufen (a) nach dem Stand der Technik benutzen:
1. Einführung der lichtempfindlichen Gruppe in die Monomerbausteine und danach Aufbau der höhermolekularen Vorstufen.
   Ein typisches Beispiel für diesen Weg wird in der DE-24 37 397 angegeben, nämlich die Addition von Allylalkohol an Pyromellitsäureanhydrid, Umsetzung des entstandenen Halbesters mit Thionylchlorid zum Säurechlorid und aus diesem Aufbau der Polymeren mit Diaminen.
   Weitere Schriften zum Stand der Technik, die Aufbauwege von ungesättigten monomeren Bausteinen ausgehend beschreiben sind z.B. DE-A-24 37 369, DE-A-24 37 413, DE-A-29 19 840, DE-A- 29 19 841, DE-A-34 11 660, DE-A-34 11 697, DE-A-34 11 706, DE-A-34 11 714, US 4 551 522 und US 4 558 117.
2. Ein anderer Weg zur Einführung lichtempfindlicher ungesättigter Gruppen besteht darin, zunächst polymere bzw. oligomere Produkte ohne lichtempfindliche Gruppen aufzubauen und in diese dann lichtempfindliche Gruppen einzuführen.
   Ein typisches Beispiel für diesen Weg wird z.B. in der DE-A-29 33 826 beschrieben: Es werden Pyromellitsäureanhydrid und Diaminodiphenyloxid, in Dimethylacetamid als Lösemittel, zu einem Polyamid addiert das Carboxylgruppen enthält. An diesen Carboxylgruppen werden dann mit Glycidylmethacrylat Doppelbindungen eingeführt, wodurch die Vorprodukte gebildet werden, die in Gegenwart von Photoinititatoren unter UV-Licht vernetzbar sind.
   Weitere Schriften zum Stand der Technik, in welchen die nachträgliche Einführung von lichtempfindlichen Gruppen in polymere Vorprodukte beschrieben ist, sind z.B. DE-A-29 33 827 und DE-A-30 21 748.

Erfindungsgemäß werden polymer und/oder oligomere Vorstufen (a) für Polyimide, Polyisoindolochinazolindinonen, Polyoxazindionen, Polychinazolindione und verwandte Polyheterocyclen einer Strahlenvernetzung dadurch zugänglich gemacht, daß sie aus Bausteinen aufgebaut werden, die leicht zu abstrahierende Wasserstoffatome besitzen und diese dann in Kombination mit Carbonylverbindungen (b), das sind Carbonylverbindungen, die im durch Licht, bevorzugt UV-Licht, angeregten Zustand zur Wasserstoffabstraktion befähigt sind, zu verwenden sind.

Vorstufen (a) im Sinne der Erfindung tragen direkt an der Polymerhauptkette Strukturglieder, die leicht zu abstrahierende Wasserstoffatome besitzen, z.B. Isoalkylreste, wie Isopropyl-, Isobutyl-, Ethylhexyl-, Methylcyclohexylreste, weiter Amino-isoalkylreste, wie Diisopropylaminomethyl-, Isopropylaminoalkyl-, N-Isobutyl-isopropyl-aminoalkylreste, Furfuryl-, Tetrahydrofurfuryl-, Benzyl-, Cumyl-, p-Menthyl-, Terpin- und Thymolylreste.

Diese Reste können auch weiter substituiert, insbesondere alkyliert und/oder halogeniert sein.

Carbonylverbindungen sind bevorzugt aromatische Ketone, wie Benzophenon, Xanthon, Thioxanthon, Fluorenon, Benzil, Acenaphthenchinon, Tetralon, Benzylidenaceton, Dibenzylidenaceton, Benzoin, Benzoinether, Naphthochinon, Anthrachinon, Anthron und die aus diesen Grundkörpern, z.B. durch Halogenierung oder Alkylierung, abgeleiteten Carbonylverbindungen sowie aromatisch/aliphatische Ketone wie Acetophenon und Propiophenon.

Besonders bevorzugt sind Benzophenon und Benzophenonderivate, allein oder im Gemisch, wie z.B. 2-, 3- oder 4-Hydroxibenzophenon, Benzophenon-2-carbonsäure, Benzophenon-3-carbonsäure, Benzophenon-4-carbonsäure, 3,3′,4,4′-Benzophenontetracarbonsäure und deren Anhydrid, 3,3′,4,4′-Tetra- (tert.-butylperoxycarbonyl)-benzophenon, 2-, 3-, 4-Phenylbenzophenon, 2-, 3-, 4-Alkylbenzophenone mit 1 bis 10 C-Atomen im Alkylrest, halogenierte (Monoalkyl)benzophenone, wie 4(Trifluormethyl)benzophenon. Geeignet sind auch Heterocerdianthron und dessen Endoperoxid. Weiter geeignet sind Ketone wie 2-Acetonaphthon, 4-Aminobenzophenon sowie 4,4'-Tetramethylaminobenzophenon und die Salze dieser Amine. Weiter lassen sich auch aliphatische Ketone wie Aceton, Methylisobutylketon, Isoamylketon und Copolymerisate von Kohlenmonoxid mit Ethylen verwenden.

Mit Vorteil lassen sich auch Gemische der Carbonylverbindungen einsetzen.

Die Carbonylverbindung wird dabei in Mengen von 0,001 bis 200 %, bevorzugt 1 bis 20 Gew.%, bezogen auf die Vorstufe (a), angewandt. Die Carbonylverbindungen können in fester, gelöster, dispergierter oder geschmolzener, monomerer und/oder polymerer Form angewandt werden.

Die vorteilhaft einzusetzende Art und Menge der Carbonylverbindung (b) wird u.a. bestimmt von der gewünschten Auftragsdicke, dem Polymerisationsgrad der Vorstufe (a), dem chemischen Aufbau der Vorstufe (a) und dem Spektrum der verwendeten UV-Strahlenquelle.

Weiter ist es möglich z.B. zur Verbesserung der Lichtempfindlichkeit und/oder zur Anpassung der Absorption an eine UV-Strahlenquelle zusätzlich nichtcarbonylische Photoinitiatoren, Sensibilisatoren und/oder bestimmte Farbstoffe zuzugeben.

Die Auswahl geeigneter weiterer Stabilisatoren, Photoinitiatoren und/oder Farbstoffe erfolgt nach dem Stand der Technik und ist nicht Gegenstand der vorliegenden Erfindung.

Als gegebenenfalls weiterhin einzusetzende übliche Hilfs- und Zusatzstoffe kommen insbesondere oberflächenaktive Mittel zur Verlaufsverbesserung und viskositätsregelnde Stoffe in Frage.

Der Aufbau der polymeren und/oder oligomeren carboxylgruppenhaltigen Reste R¹ tragenden Vorstufen (a) erfolgt nach dem Stand der Technik und geht im allgemeinen von Polycarbonsäuren und/oder Polycarbonsäureanhydriden, Polyhydroxipolycarbonsäuren, Polyaminopolycarbonsäuren, bevorzugt von Tetracarbonsäuren bzw. Tetracarbonsäuredianhydriden aus, die in der Formel (I) den Rest Q bilden.

Abgeleitet von diesem Rest Q weisen die Endprodukte (C) bevorzugt folgende Struktureinheiten auf: 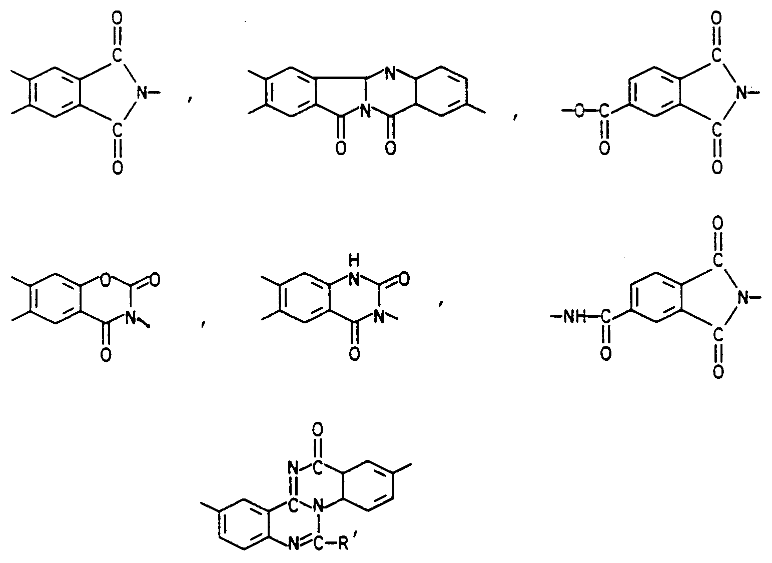
- R' =: Alkyl mit 1 bis 6 Kohlenstoffatomen, Isoalkyl mit 3 bis 12 Kohlenstoffatomen oder H
Beispiele für Polycarbonsäuren, über die der Rest Q der Formel (I) eingeführt werden kann, sind z.B. die folgenden Säuren bzw. deren Anhydride: 2,3,9,10-Perylentetracarbonsäure, 1,4,5,8-Naphthalintetracarbonsäure, 2,6-Dichlornaphthalin-1,4,5,8-tetracarbonsäure, 2,7-Dichlornaphthalin-1,4,5,8-tetracarbonsäure, Phenanthren-1,8,9,10-tetracarbonsäure, Pyromellitsäure, Trimellitsäure, 3,3',4,4'-Biphenyltetracarbonsäure, 2,2',4,4'-Biphenyltetracarbonsäure, 4,4'-Isopropylidendiphthalsäure, 3,3'-Propylidendiphthalsäure, 4,4'-Oxydiphthalsäure, 4,4'-Sulfonyldiphthalsäure, 3,3'-Oxydiphthalsäure, Dicarboxydihydroxydiphenylmethanisomere, Diaminodicarboxydiphenylmethanisomere, Dicarboxyldihydroxyphenyloxidisomere, Diaminodicarboxyldiphenyloxidisomere, Dicarboxyldihydroxydiphenylsulfonisomere, Diaminodicarboxyldiphenylsulfoxidisomere, 4,4'-Methylendiphthalsäure, 4,4'-Thiodiphthalsäure, 4,4'-Acetylidendiphthalsäure, 2,3,6,7-Naphthalintetracarbonsäure, 1,2,4,5-Naphthalintetracarbonsäure, 1,2,3,5-Naphthalintetracarbonsäure, Benzol-1,2,3,4-tetracarbonsäure, Thiophen-2,3,4,5-tetracarbonsäure, 1-(3',4'-Dicarboxyphenyl)-1,3,3-trimethylindan-5,6-dicarbonsäure, 1-(3',4'-Dicarboxyphenyl)-1,3,3-trimethylindan-6,7-dicarbonsäure, Pyrazin-2,3,5,6-tetracarbonsäure, Tetrahydrofurantetracarbonsäure, 9-Brom-10-merkaptoanthracentetracarbonsäure, 9,10-Dimerkaptoanthracendicarbonsäure, Benzophenontetracarbonsäure sowie Substitutionsprodukte dieser Polycarbonsäuren, insbesondere Halogen- und/oder Alkylsubstitutionsprodukte.

Zur Einführung der Reste R³ in die Vorprodukte (a) wird im allgemeinen von Diaminen oder Diisocyanaten ausgegangen.

Geeignete Diamine sind z.B. 4,4-Diaminodiphenylether, 4,4-Methylenbis-(o-chloranilin), 3,3′-Dichlorbenzidin, 3,3′-Sulfonyldianilin, 4,4′-Diaminobenzophenon, 1,5-Diaminonaphthalin, Bis-(4-aminophenyl)-dimethylsilan, Bis-(4-aminophenyl)-diethylsilan, Bis-(4-aminophenyl)-diphenylsilan, Bis-(4-aminophenyloxy)-dimethylsilan, Bis-(4-aminophenyl)-ethylphosphinoxid, N-(Bis-(4-aminophenyl))-N-methylamin, N-(Bis-(4-aminophenyl))-N-phenylamin, 4,4′-Methylbis-(3-methylanilin), 4,4′-Methylenbis-(2-ethylanilin), 4,4′-Methylenbis-(2-methoxyanilin), 5,5′-Methylenbis-(2-aminophenol), 4,4′-Methylenbis-(2-methylanilin), 5,5′-Oxybis-(2-aminophenol), 4,4′-Thiobis-(2-methylanilin), 4,4′-Thiobis-(2-methoxyanilin), 4,4′-Thiobis-(2-chloranilin), 4,4′-Sulfonylbis-(2-ethoxyanilin), 4,4′-Sulfonylbis-(2-chloranilin), 5,5′-Sulfonylbis-(2-aminophenol), 3,3′-Dimethyl-4,4′-Diaminobenzophenon, 3,3′-Dimethoxy-4,4′-diaminobenzophenon, 3,3′-Dichlor-4,4′-diaminobenzophenon, 4,4′-Diaminobiphenyl, m-Phenylendiamin, p-Phenylendiamin, 4,4′-Methylendianilin, 4,4′-Oxydianilin, 4,4′-Thiodianilin, 4,4′-Sulfonyldianilin, 4,4′-Isopropylidendianilin, 3,3′-Dimethylbenzidin, 3,3′-Dimethoxybenzidin, 3,3′-Dicarboxybenzidin, Diaminotoluol.

Diamine mit leicht abstrahierbaren Wasserstoffatomen sind z.B. Diaminodicyclohexyl-methan, Diamino-(dimethyl)-dicyclohexyl-methan, Diamino-(-dimethyl-diisopropyl)-dicyclohexyl-methan, Diamino-(tetraisopropyl)-dicyclohexyl-methan, Diamino-(diisopropyl)-dicyclohexylmethan, Diisopropyltoluylendiamin, Alkyl-isopropyl-toluylendiamin, Diamino-diisopropyl-diphenylmethan, Diamino-diisopropyl-diphenyloxid, Diamino-diphenyl-propan u.a.

Der Begriff "Diamine" soll dabei auch Verbindungen umfassen, die das Strukturelement 〉N-N〈 enthalten, d.h. Abkömmlinge des Hydrazins.

Geeignete Diisocyanate sind z.B. Toluylendiisocyanat, Isophorondiisocyanat, Diisocyanatodiphenylmethan, Trimethyl-hexamethylendiisocyanat, Hexamethylendiisocyanat, Dicyclohexylmethandiisocyanat und die über Uretdiongruppen aufgebauten Dimere dieser Isocyanate, weiter monomere, oligomere und/oder polymere Diisocyanate, die aus der Reaktion von, mit Isocyanatgruppen bifunktionellen Verbindungen, z.B. Diaminen oder Diolen, mit Diisocyanaten erhalten werden.

In diesen Fällen können die leicht abstrahierbaren Wasserstoffatome auch in den bifunktionellen Verbindungen enthalten sein, z.B. ist zum erfindungsgemäßen Aufbau der Vorstufe (a) das Reaktionsprodukt aus 4,4′-Methylen-bis-(2,6-diisopropylanilin) mit einem äquivalenten Überschuß von Diisocyanato-diphenylmethan geeignet, wobei es Stand der Technik ist, die Länge der Molekülkette zwischen monomeren und polymeren Stoffen durch die Größe des Überschusses an Diisocyanat zu bestimmen.

Die aufgeführten Ausgangsstoffe sind bekannt oder können nach an sich bekannten Verfahren hergestellt werden.

Die leicht abstrahierbaren Wasserstoffatome sind erfindungsgemäß in den Strukturgliedern Q und/oder R³, d.h. in der Polymerhauptkette, der allgemeinen Formel (I) vorhanden.

Weiter ist es gegebenenfalls möglich, zusätzlich Strukturglieder R² und/oder R¹ einzuführen, die ebenfalls zur leichten Abgabe von Wasserstoffatomen befähigt sind.

Es werden bevorzugt solche Vorstufen (a) aufgebaut, die nach der Überführung in den Endzustand (C) eine hohe Temperaturbeständigkeit aufweisen.

Der Aufbau der polymeren Vorstufen (a) erfolgt im allgemeinen zweckmäßigerweise in geeigneten organischen Lösemitteln, das sind insbesondere Formamid, Acetamid, N-Methylformamid, N,N-Dimethylformamid, N-Methylpyrrolidon, N,N-Dimethylacetamid, Butyrolacton, Caprolactam, Hexamethylphosphorsäuretrisamid u.a.

Die Herstellung der erfindungsgemäßen Vorstufen (a) erfolgt bevorzugt nach dem unter 2. beschriebenen Weg.

Dabei werden aromatische und/oder heterocyclische Tetracarbonsäureanhydride mit Diaminoverbindungen und/oder Diaminoverbindungen mit wenigstens einer orthoständigen Amidogruppe bzw. aromatische und/oder heterocyclische Dihydroxydicarbonsäuren und/oder Diaminodicarbonsäuren mit Diisocyanaten zu carboxylgruppenhaltigen Polyadditionsprodukten umgesetzt.

Dabei können leicht abstrahierbare Wasserstoffatome sowohl in den Tetracarbonsäureanhydriden, bzw. Dihydroxydicarbonsäuren bzw. Diaminodicarbonsäuren vorhanden sein, d.h. nach der Umsetzung im Strukturglied Q der Formel (I) und/oder in den Diaminoverbindungen bzw. in den Diisocyanaten, d.h. nach der Umsetzung in den Strukturgliedern R³ der Formel (I).

In diese carboxylgruppenhaltigen Polyadditionsprodukte können gegebenenfalls Strukturglieder R¹ und/oder R² eingeführt werden, die ebenfalls leicht abstrahierbare Wasserstoffatome und/oder Doppelbindungen besitzen und in Kombination mit bestimmten Carbonylgruppen oder Photoinitiatoren oder Bisaziden lichtempfindlich sind.

Reste R¹ und/oder R³ der genannten Art können z.B. in der Weise eingeführt werden, daß solche Reste R¹ und/oder R³ die Amin- oder Hydroxygruppen tragen, über Amid- bzw. Estergruppen nach bekannten Methoden der organischen Chemie mit den Carboxylgruppen der Polyadditionsverbindungen verknüpft werden.

Weiter ist es möglich, Reste R¹ und/oder R³ der oben genannten Art, die Epoxid- oder Isocyanatgruppen tragen, mit carboxylgruppenhaltigen Polyadditionsprodukten, die in der Polymerhauptkette leicht abstrahierbare Wasserstoffatome besitzen und in erfindungsgemäßer Gegenwart von Carbonylverbindungen lichtempfindlich sind, umzusetzen und dadurch zu weiteren erfindungsgemäßen Vorprodukten (a) zu gelangen.

Wichtigster Verwendungszweck der erfindungsgemäßen Produkte sind Photoresists, wobei nach Belichtung unter einer Maske, mit geeigneten Lösemitteln eine Strukturierung erfolgt und die strukturierten Schichten dann unter Anwendung höherer Temperaturen in die Endfunktionsschicht (C) überführt werden.

Aber auch andere Verwendungen als Isolier- und Schutzschichten in der Elektrotechnik, Elektronik und Mikroelektronik sind möglich, wobei die erfindungsgemäßen Stoffe in den Stufen (B) und (C) eingesetzt werden.

Die erfindungsgemäßen strahlungsreaktiven Massen können auch vorteilhaft für Überzüge auf Lichtleiterfasern verwendet werden.

Anhand der Ausführungsbeispiele soll die Erfindung noch näher erläutert werden.

Die in den Beispielen genannten Teile und Prozente sind, soweit nicht anders angegeben, Gewichtsteile und Gewichtsprozente.

### Vergleichsbeispiel 1

Herstellung eines carboxylgruppenhaltigen Polyadditionsproduktes:
109 Teile Pyromellithsäureanhydrid (0,5 Mol) und
486 Teile N-Methylpyrrolidon
werden bei 60°C unter Rühren in einem Reaktionskolben, der Druckausgleich über ein mit Trockenmittel gefülltes U-Rohr hat, unter reinstem Stickstoff gelöst.

Über einen Tropftrichter wird eine Lösung von
100 Teilen Diaminodiphenyloxid (0,5 Mol) in
350 Teilen N-Methylpyrrolidon
in einer Stunde zugegeben, die Temperatur steigt dabei auf 66°C an. Es wird eine Stunde bei 75°C gerührt und dann abgekühlt, es resultiert eine viskose Harzlösung.

### Charakterisierung:

- SZ: : 53,2;
- Viskosität: : 5750 mPas bei D = 100 l/s
- IR-Spektrum: : typische Amidbandenkombination bei 1720, 1663, 1543, 1500 und 1240 l/cm.

Diese Harzlösung wird mit und ohne Zusatz von 2 % Benzophenon geprüft (vgl. Tabelle).

### Beispiel 1

109 Teile Pyromellithsäureanhydrid (0,5 Mol) und
486 Teile N-Methylpyrrolidon
werden bei 60°C unter Rühren in einem Reaktionskolben, der Druckausgleich über ein mit Trockenmittel gefülltes U-Rohr hat, unter reinstem Stickstoff gelöst.

Über einen Tropftrichter wird eine Lösung von
147 Teilen Diaminodiisopropyl-(bis-cyclohexyl-methan (0,5 Mol) in
350 Teilen N-Methylpyrrolidon
in einer Stunde zugegeben, die Temperatur steigt dabei auf 66°C an. Es wird eine Stunde bei 75°C gerührt und dann abgekühlt. Es resusltiert eine viskose Harzlösung.

### Charakterisierung:

- SZ: : 49,1;
- Viskosität: : 1014 mPas bei D = 100 l/s
- IR-Spektrum: : typische Amidbandenkombination bei 1720, 1663, 1543, 1500 und 1240 l/cm.

Diese Harzlösung wird mit und ohne Zusatz von 2 % Benzophenon geprüft (vgl. Tabelle).

### Zwischenprodukt für Beispiel 2:

### (Isocyanat mit Resten R¹)

174 Teile 2,4-Toluylendiisocyanat (1 Mol = 2 Äquivalent)
werden unter Rühren mit einer Lösung von
72 Teilen Tetrahydrofurfurylalkohol (1 Mol = 1 Äquivalent)
0,1 Teilen Dibutylzinndilaurat
0,1 Teilen Benzoylchlorid in
127 Teilen n-Butylacetat
in zwei Stunden tropfenweise versetzt. Die Temperatur steigt dabei von 23°C auf 39°C. Es wird noch zwei Stunden bei 35°C nachgerührt. Es resultiert eine niederviskose Flüssigkeit mit einem NCO-Gehalt von 10,8 %.

### Beispiel 2

200 Teile der Polymerlösung gemäß Beispiel 1 und
0,3 Teile Dimethylaminopyridin
werden unter Rühren in einem Glaskolben mit aufgesetztem Blasenzähler rasch mit
76 Teilen des Isocyanats mit Resten R¹
versetzt. Es setzt eine Gasentwicklung ein, die nach etwa zwei Stunden nachläßt. Dann wird zwei Stunden bei 60°C weitergerührt, wobei die Gasentwicklung zunächst wieder stärker wird und dann aufhört.

### Charakterisierung:

- SZ: : 21
- Viskosität: : 938 mPas bei D = 100 l/s
- IR-Spektrum: : keine Isocyanatbanden

Diese Harzlösung wird mit und ohne Zusatz von 2 % Benzophenon geprüft (vgl. Tabelle).

### Beispiel 3

192 Teile Trimellitsäureanhydrid und
200 Teile N-Methylpyrrolidon
werden in einem Rührkolben mit Rückflußkühler und Blasenzähler gelöst. Über einen Tropftrichter werden
111 Teile Isophorondiisocyanat
innerhalb von zwei Stunden zugetropft. Die Temperatur steigt auf 36°C und es setzt eine Gasentwicklung ein. Nach Zulaufende wird noch zwei Stunden bei 70°C weitergerührt bis die Gasentwicklung beendet ist. Dann werden
100 Teile Diaminodiphenyloxid gelöst in
203 Teilen N-Methylpyrrolidon
in einer Stunde zugegeben. Es resultiert eine braune niederviskose Polymerlösung.

Diese Polymerlösung wird mit und ohne Zusatz von 2 % Benzophenon geprüft (vgl. Tabelle).

### Beispiel 4

206 Teile Polyadditionsprodukt laut Beispiel 1
werden in einem Rührkolben innerhalb von 15 Minuten mit einer Lösung von
18,6 Teilen Tetrahydrofurfurylamin in
43,4 Teilen N-Methylpyrrolidon
versetzt. Dabei steigt die Temperatur auf 34°C. Es wird weiter innerhalb von 30 Minuten eine Lösung von
39,6 Teilen Dicyclohexylcarbodiimid in
92,4 Teilen N-Methylpyrrolidon
zugegeben. Dabei steigt die Temperatur auf 38°C und es bildet sich ein Niederschlag. Es wird noch eine Stunde bei 60°C weitergerührt, abgekühlt und vom Niederschlag abfiltriert. Es resusltiert eine bräunliche Harzlösung mit einer Viskosität von 870 mPas bei D = 100 s⁻¹.

Diese Harzlösung wird mit und ohne Zusatz von 2 % Benzophenon geprüft (vgl. Tabelle).

### Prüfung der Produkte gemäß den Beispielen und Vergleichsbeispiel

Harzlösungen nach dem Vergleichsbeispiel und den Beispielen 1 bis 4 werden tel quel und mit 2 % Benzophenon, bezogen auf den Harzgehalt, auf Glasplatten aufgerakelt und bei 50°C im Vakuum 3 Stunden getrocknet. Es werden klebfreie hellbräunliche Filme von 25 bis 30 µm erhalten. Diese werden zur Hälfte mit Aluminiumfolie abgedeckt, unter einer Quecksilberhochdrucklampe 15 Minuten belichtet und dann mit einer Mischung aus Ethanol/N-Methyl-pyrrolidon 1:1, auf Unterschiede der Löslichkeit zwischen bestrahlten und abgedeckten Stellen geprüft.

Die Prüfbefunde zeigt die folgende Tabelle

| Harz | Benzophenon | Löslichkeit | |
|---|---|---|---|
| | | unbelichtet | belichtet |
| Vergleichsbeispiel | - | löslich | löslich |
| | + | löslich | löslich |
| Beispiel 1 | - | löslich | löslich |
| | + | löslich | unlöslich |
| Beispiel 2 | - | löslich | löslich |
| | + | löslich | unlöslich |
| Beispiel 3 | - | löslich | löslich |
| | + | löslich | unlöslich |
| Beispiel 4 | - | löslich | löslich |
| | + | löslich | unlöslich |

- löslich bedeutet :: läßt sich mit einem lösemittelgetränkten Wattebausch mit leichtem Reiben entfernen.
- unlöslich bedeutet :: läßt sich mit einem lösemittelgetränkten Wattebausch nicht oder nur nach längerem starken Reiben als bröselig vernetztes Harz entfernen.

## Patentansprüche

1. Strahlungsempfindliches, zur Herstellung von Polyimiden, Polyisoindolochinazolindionen, Polyoxazindionen, Polychinazolindionen oder Polychinazolonen geeignetes Gemisch, das bei Bestrahlung mit aktinischem Licht eine Löslichkeitsdifferenzierung erfährt, dadurch gekennzeichnet, daß das strahlungsempfindliche Gemisch besteht aus
(a) einer oder mehreren Vorstufen, die Strukturelemente der allgemeinen Formel (I) aufweisen, 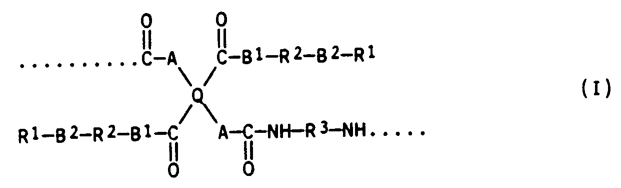 worin
A = -O-, -NH-, oder eine Einfachbindung,
Q = ein gegebenenfalls halogensubstituierter aromatischer oder heterocyclischer tetravalenter Rest, oder ein zwei über eine Brückengruppe miteinander verbundene bivalente aromatische Reste enthaltender Rest, in dem jeweils zwei der Valenzen in Nachbarstellung zueinander angeordnet sind,
B¹ = -O- oder -NR⁴-,
B² = -NH-CO-NH-, -NH-CO-O-, -NH-CO- oder eine Einfachbindung,
R¹ = H, Alkyl, Aryl, ein ethylenisch ungesättigter Rest oder ein leicht wasserstoffabgebender Rest aus der Gruppe Isoalkyle, Aminoisoalkyle, Cycloisoalkyle, Cycloisoalkyle mit einem oder mehreren Heteroatomen, Isoalkylaryle oder Gruppierungen folgender allgemeiner Formeln ausgewählt ist 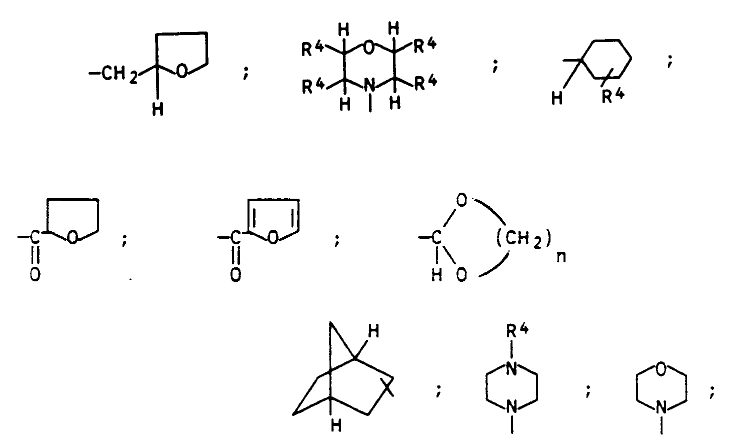 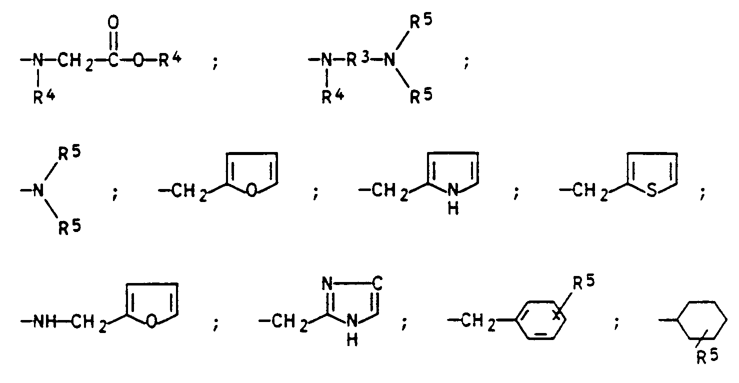
worin
n = 2 oder 3
und
R² = ein bivalenter aliphatischer oder aromatischer Rest oder eine Einfachbindung,
R³ = ein bivalenter aliphatischer, cycloaliphatischer, aromatischer oder heterocyclischer Rest, der gegebenenfalls halogensubstituiert ist, oder eine Einfachbindung,
R⁴ = H, geradkettiges oder verzweigtes Alkyl, das halogensubstituiert sein kann, und
R⁵ = Alkyl, Aryl, halogensubstituiertes Alkyl, halogensubstituiertes Aryl oder Isoamylphenyl,
mit der Maßgabe, daß mindestens einer der Reste Q und R³ ein Isoalkyl-, Methylcyclohexyl-, Amino-isoalkyl-, Furfuryl-, Tetrahydrofurfuryl-, BenzyI-, Cumyl-, p-Menthyl-, Terpin- und/oder Thymolylrest ist,
(b) einer oder mehreren aromatische Reste enthaltenden Carbonylverbindungen, die im durch UV-Strahlung angeregten Zustand zur Wasserstoffabstraktion befähigt sind, gegebenenfalls zusätzlich aliphatische Ketone und Copolymerisate von Kohlenmonoxid mit Ethylen allein oder in Kombination mit den oben genannten Carbonylverbindungen, sowie gegebenenfalls
(c) einem oder mehreren Stoffen aus der Gruppe Photoinitiator, Photosensibilisator, (Leuko)Farbstoff und aliphatisches Keton, wobei zur Prüfung der Strahlungsempfindlichkeit dieser Gemische, deren Harzlösugnen mit 2 % Benzophenon, bezogen auf den Harzgehalt, auf Glasplatten aufgerakelt, bei 50°C im Vakuum 3 Stunden getrocknet, die so erhaltenen 25 bis 30 µm dicken klebfreien Filme zur Hälfte mit Aluminiumfolie abgedeckt, unter einer Quecksilberhochdrucklampe 15 Minuten belichtet und dann durch Reiben mit eins mit einer Mischung aus Ethanol/N-Methylpyrrolidon 1:1 getränkten Wattebausch auf Unterschiede der Löslichkeit zwischen bestrahlten und abgedeckten Stellen geprüft werden.

2. Strahlungsempfindliches Gemisch nach Anspruch 1, dadurch gekennzeichnet, daß als aromatische Reste enthaltende Carbonylverbindung (b) mindestens ein aromatisches Keton aus der Gruppe Benzophenon, Xanthon, Thioxanthon, Fluorenon, Benzil, Acenaphthenchinon, Tetralon, Benzylidenaceton, Dibenzylidenacetophenon, Benzoin, Benzoinether, Benzanilid, Acetophenon, Propiophenon, Naphthochinon, Anthrachinon, Anthron, 2-, 3- und 4-Hydroxibenzophenon, Benzophenon-2-carbonsäure, Benzophenon-3-carbonsäure, Benzophenon-4-carbonsäure, 3,3',4,4'-Benzophenontetracarbonsäure und deren Anhydrid, 3,3',4,4'-Tetra-(tert.-butylperoxycarbonyl)-benzophenon, 2-, 3- und 4-Phenylbenzophenon, 2-, 3- und 4-Alkylbenzophenone mit 1 bis 10 C-Atomen im Alkylrest, halogeniertes (Monoalkyl)benzophenon und 4-(Trifluormethyl)-benzophenon eingesetzt wird.

3. Strahlungsempfindliches Gemisch nach einem der Ansprüche 1 oder 2, dadurch gekennzeichnet, daß als Carbonylverbindungen (b) Heterocerdianthron und dessen Endoperoxid, oder 2-Acetonaphthon, 4-Aminobenzophenon, 4,4'-Tetramethylaminobenzophenon und die Salze dieser Amine sowie gegebenenfalls zusätzlich aliphatische Ketone, wie Aceton, Methylisobutylketon, Isoamylketon und Copolymerisate von Kohlenmonoxid mit Ethylen allein oder in Kombination mit den in Anspruch 2 genannten Carbonylverbindungen verwendet werden.

4. Strahlungsempfindliches Gemisch nach einem der Ansprüche 1 bis 3, dadurch gekennzeichnet, daß die Carbonylverbindung (b) in einer Menge von 0,001 bis 200 Gew.%, bezogen auf die Vorstufe (a) eingesetzt wird.

5. Strahlungsempfindliches Gemisch nach einem der Ansprüche 1 bis 4, dadurch gekennzeichnet, daß die Carbonylverbindungen (b) in fester, gelöster, dispergierter oder geschmolzener, monomerer und/oder polymerer Form eingesetzt werden.

6. Strahlungsempfindliches Gemisch nach einem der Ansprüche 1 bis 5, dadurch gekennzeichnet, daß zur Verbesserung der Lichtempfindlichkeit und/oder zur Anpassung der Absorption an eine UV-Strahlenquelle zusätzlich nichtcarbonylische Photoinitiatoren und/oder bestimmte Farbstoffe zugegeben werden.

7. Strahlungsempfindliches Gemisch nach einem der Ansprüche 1 bis 6, dadurch gekennzeichnet, daß die Vorstufen (a) in monomerer, oligomerer oder polymerer Form oder in Mischungen verschiedener Polymerisationsstufen eingesetzt werden.

8. Strahlungsempfindliches Gemisch nach einem der Ansprüche 1 bis 7, dadurch gekennzeichnet, daß die Vorstufen (a) Vorstufen für Polyimide, Polyisoindolochinazolindione, Polyoxazindione oder Polychinazolindione sind.

9. Strahlungsempfindliches Gemisch nach einem der Ansprüche 1 bis 8, dadurch gekennzeichnet, daß als Vorstufen (a) solche eingesetzt werden, die durch Verknüpfung carboxylgruppenhaltiger Polyadditionsprodukte aus aromatischen und/oder heterocyclischen Tetracarbonsäureanhydriden und Diaminoverbindungen an den Carboxylgruppen mit Resten R¹ über eine Ester-, Ether-, Amid- oder Urethangruppe erhalten worden sind.

10. Strahlungsempfindliches Gemisch nach einem der Ansprüche 1 bis 8, dadurch gekennzeichnet, daß als Vorstufen (a) solche eingesetzt werden, die durch Verknüpfung carboxylgruppenhaltiger Polyadditionsprodukte aus aromatischen und/oder heterocyclischen Dihydroxydicarbonsäuren und Diisocyanaten an den Carboxylgruppen mit Resten R¹ über eine Ester-, Ether-, Amid- oder Urethangruppe erhalten worden sind.

11. Strahlungsempfindliches Gemisch nach einem der Ansprüche 1 bis 8, dadurch gekennzeichnet, daß als Vorstufen (a) solche eingesetzt werden, die durch Verknüpfung carboxylgruppenhaltiger Polyadditionsprodukte aus aromatischen und/oder heterocyclischen Diaminodicarbonsäuren und Diisocyanaten an den Carboxylgruppen mit Resten R¹ über eine Ester-, Ether-, Amid- oder Urethangruppe erhalten worden sind.

12. Verfahren zur Herstellung von strahlungsempfindlichen Gemischen nach einem der vorhergehenden Ansprüche, dadurch gekennzeichnet, daß zur Einführung der Reste R¹ in die Vorstufen (a), carboxylgruppenhaltige Polyadditionsprodukte aus aromatischen und/oder heterocyclischen Diaminodicarbonsäuren und Diisocyanaten und/oder carboxylgruppenhaltige Polyadditionsprodukte aus aromatischen und/oder heterocyclischen Dihydroxydicarbonsäuren und Diisocyanaten und/oder carboxylgruppenhaltige Polyadditionsprodukte aus aromatischen und/oder heterocyclischen Tetracarbonsäureanhydriden und Diaminoverbindungen, mit Monoaddukten von Diisocyanaten mit Verbindungen der Struktur R¹-OH, R¹-NH₂, R¹-B²-NH₂ und/oder R¹-COOH umgesetzt werden.

13. Verfahren nach Anspruch 12, dadurch gekennzeichnet, daß in die carboxylgruppenhaltigen Polyadditionsprodukte aus aromatischen und/oder heterocyclischen Diaminodicarbonsäuren und Diisocyanaten und/oder carboxylgruppenhaltigen Polyadditionsprodukte aus aromatischen und/oder heterocyclischen Dihydroxydicarbonsäuren und Diisocyanaten und/oder carboxylgruppenhaltigen Polyadditionsprodukte aus aromatischen und/oder heterocyclischen Tetracarbonsäureanhydriden und Diaminoverbindungen die Reste R¹ in einer solchen Menge eingeführt werden, daß das Verhältnis der Reste R¹ zu den Carbonxylgruppen der carboxylgruppenhaltigen Polyadditionsprodukte 1:1 bis 0,05 bis 1 beträgt.

14. Verfahren nach einem der Ansprüche 12 oder 13, dadurch gekennzeichnet, daß als Tetracarbonsäureanhydrid Pyromellitsäureanhydrid und/oder Benzophenontetracarbonsäureanhydrid eingesetzt werden.

15. Verfahren nach einem der Ansprüche 12 oder 13, dadurch gekennzeichnet, daß als Dihydroxidicarbonsäure 4,4′-Dihydroxydiphenylmethan-3,3′-dicarbonsäure eingesetzt wird.

16. Verfahren nach einem der Ansprüche 12 oder 13, dadurch gekennzeichnet, daß als Diaminodicarbonsäure 4,4′-Diaminodiphenylmethan-3,3′-dicarbonsäure eingesetzt wird.

17. Strahlungsempfindliches Gemisch nach einem der Ansprüche 1 bis 11, dadurch gekennzeichnet, daß die Vorstufen (a) nicht ausschließlich über die Reste R¹ vernetzbar sind, sondern daß sie weitere strahlungsempfindliche Reste enthalten, insbesondere Reste mit ethylenischen Doppelbindungen und/oder andere Reste die mit Bisaziden vernetzen.

18. Strahlungsempfindliches Gemisch nach einem der Ansprüche 1 bis 8, dadurch gekennzeichnet, daß der Rest Q der allgemeinen Formel (I) sich ableitet von 2,3,9,10-Perylentetracarbonsäure, 1,4,5,8-Naphthalintetracarbonsäure, 2,6-Dichlornaphthalin-1,4,5,8-tetracarbonsäure, 2,7-Dichlornaphthalin-1,4,5,8-tetracarbonsäure, Phenanthren-1,8,9,10-tetracarbonsäure, Pyromellitsäure, 3,3′,4,4′-Biphenyltetracarbonsäure, 2,2′,4,4′-Biphenyltetracarbonsäure, 4,4′-Isopropylidendiphthalsäure, 3,3′-Propylidendiphthalsäure, 4,4′-Oxydiphthalsäure, 4,4′-Sulfonyldiphthalsäure, 3,3′-Oxydiphthalsäure, Dicarboxydihydroxydiphenylmethanisomeren, Diaminodicarboxydiphenylmethanisomeren, Dicarboxyldihydroxidiphenyloxidisomeren, Diaminodicarboxylidiphenyloxidisomeren, Dicarboxyldihydroxydiphenylsulfonisomeren, Diaminodicarboxyldiphenylsulfoxidisomeren, 4,4′-Methylendiphthalsäure, 4,4′-Thiodiphthalsäure, 4,4′-Acetylidendiphthalsäure, 2,3,6,7-Naphthalintetracarbonsäure, 1,2,4,5-Naphthalintetracarbonsäure, 1,2,3,5-Naphthalintetracarbonsäure, Benzol-1,2,3,4-tetracarbonsäure, Thiophen-2,3,4,5-tetracarbonsäure, 1-(3′,4′-Dicarboxylphenyl)-1,3,3-trimethylindan-5,6-dicarbonsäure, 1-(3′,4′-Dicarboxylphenyl)-1,3,3-trimethylindan-6,7-dicarbonsäure, Pyrazin-2,3,5,6-tetracarbonsäure, Tetrahydrofurantetracarbonsäure, 9-Brom-10-merkaptoanthracentetracarbonsäure, 9,10-Dimerkaptoanthracendicarbonsäure, Benzophenontetracarbonsäure sowie Substitutionsprodukten dieser Polycarbonsäuren, insbesondere deren Halogen- und/oder Alkylsubstitutionsprodukten.

19. Strahlungsempfindliches Gemisch nach einem der Ansprüche 1 bis 11 oder 17 bis 18, dadurch gekennzeichnet, daß die Vorstufen (a) nicht nur mit einer Art von Resten R¹ sondern mit Kombinationen unterschiedlicher Reste R¹ funktionalisiert sind.

20. Strahlungsempfindliches Gemisch nach einem der Ansprüche 1 bis 11 oder 17 bis 19, dadurch gekennzeichnet, daß die Reste R³ sich von Diaminodicyclohexyl-methan, Diamino-(dimethyl)-dicyclohexyl-methan, Diamino-(dimethyl-diisopropyl)-dicyclohexyl-methan, Diamino-(tetraisopropyl)-dicyclohexyl-methan, Diamino-(diisopropyl)-dicyclohexyl-methan, Diisopropyltoluylendiamin, Alkyl-isopropyl-toluylendiamin, Diamino-diisopropyl-diphenylmethan, Diamino-diisopropyl-diphenyloxid und/oder Diamino-diphenylpropan herleiten, die über ihre Aminogruppen and die Hauptkette der Vorstufe (a) gebunden sind.

21. Strahlungsempfindliches Gemisch nach einem der Ansprüche 1 bis 11 oder 17 bis 19, dadurch gekennzeichnet, daß die Reste R³ sich von Toluylendiisocyanat, Isophorondiisocyanat, Diisocyanatodiphenylmethan, Trimethylhexamethylendiisocyanat, Hexamethylendiisocyanat, Dicyclohexylmethandiisocyanat, die über Uretdiongruppen aufgebauten Dimere dieser Isocyanate oder monomere, oligomere und/oder polymere Diisocyanate, die aus der Reaktion von mit Isocyanatgruppen reaktiven bifunktionellen Verbindungen, wie Diaminen oder Diolen mit Diisocyanaten erhalten werden, ableiten und in der Hauptkette der Vorstufe (a) gebunden sind.

22. Strahlungsempfindliches Gemisch nach einem der Ansprüche 1 bis 11 oder 17 bis 21, dadurch gekennzeichnet, daß zusätzlich solche Reste R² und R¹ enthalten sind, die ebenfalls zur leichten Abstraktion von Wasserstoffatomen befähigt sind.

23. Strahlungsempfindliches Gemisch nach einem der Ansprüche 1 bis 11 oder 17 bis 22, dadurch gekennzeichnet, daß die strahlungsreaktiven Massen mit anderen strahlungsempfindlichen Stoffen und/oder nicht strahlungsempfindlichen Stoffen gemischt verwendet werden.

24. Verwendung der strahlungsempfindlichen Gemische nach einem der Ansprüche 1 bis 11 oder 17 bis 23 zur Erzeugung schützender und isolierender Schichten für die Anwendung beim Aufbau gedruckter Schaltungen und integrierter Schaltkreise, wobei sie einer Strahlenvernetzung und/oder thermischen Nachbehandlung unterzogen werden.

25. Verwendung der strahlungsempfindlichen Gemische nach einem der Ansprüche 1 bis 11 oder 17 bis 24 zur Erzeugung schützender und isolierender Schichten für die Anwendung beim Aufbau gedruckter Schaltungen und integrierter Schaltkreise, wobei sie unter einer Maske belichtet und dadurch partiell strahlenvernetzt, danach mit geeigneten Lösemitteln strukturiert und dann gegebenenfalls einer thermischen Nachbehandlung unterzogen werden.

## Claims

1. A radiation-sensitive mixture which is suitable for preparing a polyimide, a polyisoindoloquinazolinedione, a polyoxazinedione, a polyquinazolinedione or a polyquinazolone and which on irradiation with actinic light undergoes solubility differentiation, consisting of
(a) one or more precursors having structural elements of the general formula (I) 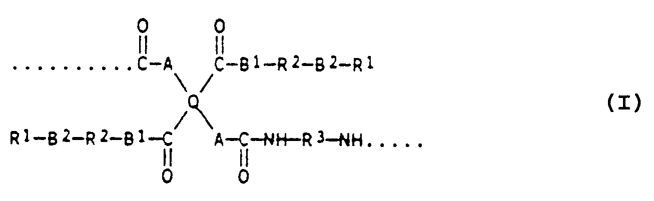 where
A is -O-, -NH- or a single bond,
Q is an unsubstituted or halogen-substituted aromatic or heterocyclic tetravalent radical, or a radical which contains two bivalent aromatic radicals linked by a bridging group, wherein two at a time of the valences are adjacent to each other,
B¹ is -O- or -NR⁴-,
B² is -NH-CO-NH-, -NH-CO-O-, -NH-CO- or a single bond,
R¹ is H, alkyl, aryl, an ethylenically unsaturated radical or a readily hydrogen-donating radical selected from the group consisting of isoalkyls, aminoisoalkyls, cycloisoalkyls, cycloisoalkyls having one or more heteroatoms, isoalkylaryls and groups of the following general formulae: 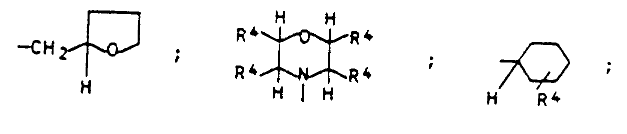 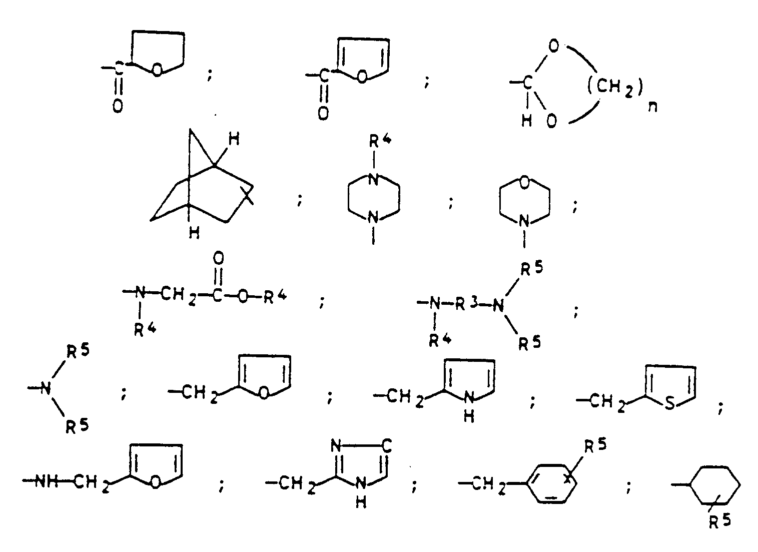
where
n is 2 or 3,
R² is a bivalent aliphatic or aromatic radical or a single bond,
R³ is a bivalent aliphatic, cycloaliphatic, aromatic or heterocyclic radical which may be halogen-substituted, or a single bond,
R⁴ is H or straight-chain or branched alkyl which may be halogen-substituted, and
R⁵ is alkyl, aryl, halogen-substituted alkyl or aryl, or isoamylphenyl,
with the proviso that at least one of Q and R³ is isoalkyl, methylcyclohexyl, aminoisoalkyl, furfuryl, tetrahydrofurfuryl, benzyl, cumyl, p-menthyl, terpinyl and/or thymolyl,
(b) one or more aryl-containing carbonyl compounds which when excited by UV radiation are capable of hydrogen abstraction, optionally also aliphatic ketones or copolymers of carbon monoxide with ethylene alone or combined with the abovementioned carbonyl compounds, and optionally
(c) one or more substances selected from the group consisting of a photoinitiator, a photosensitizer, a (leuco)dye and an aliphatic ketone, the radiation sensitivity of this mixture being tested by a procedure in which a resin solution thereof with 2% of benzophenone, based on the resin content, is drawn down on glass plates and dried at 50°C under reduced pressure in the course of 3 hours, the resulting 25-30 µm thick tack-free film is half covered with aluminium foil and exposed under a high-pressure mercury lamp for 15 minutes and then tested as to differences in the solubility between irradiated and covered areas by rubbing with a cottonwool pad impregnated with 1:1 ethanol/N-methylpyrrolidone.

2. A radiation-sensitive mixture as claimed in claim 1, wherein the aryl-containing carbonyl compound (b) used comprises one or more aromatic ketones from the group consisting of benzophenone, xanthone, thioxanthone, fluorenone, benzil, acenaphthenequinone, tetralone, benzylideneacetone, dibenzylideneacetophenone, benzoin, benzoin ether, benzanilide, acetophenone, propiophenone, naphthoquinone, anthraquinone, anthrone, 2-, 3- and 4-hydroxybenzophenone, benzophenone-2-carboxylic acid, benzophenone-3-carboxylic acid, benzophenone-4-carboxylic acid, 3,3',4,4'-benzophenonetetracarboxylic acid and anhydride, 3,3',4,4'-tetra(tert.-butylperoxycarbonyl)-benzophenone, 2-, 3- and 4-phenylbenzophenone, 2-, 3- and 4-alkylbenzophenones having from 1 to 10 carbon atoms in the alkyl radical, halogenated (monoalkyl)benzophenone and 4-(trifluoromethyl)benzophenone.

3. A radiation-sensitive mixture as claimed in claim 1 or 2, wherein carbonyl compound (b) comprises heteroceriumdianthrone and its endoperoxide or 2-acetonaphthone, 4-aminobenzophenone, 4,4'-tetramethylaminobenzophenone and the salts of these amines and optionally in addition aliphatic ketones, such as acetone, methylisobutyl ketone or isoamyl ketone or a copolymer of carbon monoxide with ethylene alone or combined with the carbonyl compounds mentioned in claim 2.

4. A radiation-sensitive mixture as claimed in any of claims 1 to 3, wherein carbonyl compound (b) is used in an amount of from 0.001 to 200% by weight, based on precursor (a).

5. A radiation-sensitive mixture as claimed in any of claims 1 to 4, wherein carbonyl compound (b) is used in a solid, dissolved, dispersed or molten, monomeric and/or polymeric form.

6. A radiation-sensitive mixture as claimed in any of claims 1 to 5, wherein to improve the speed and/or to match the absorption to a source of UV rays a non-carbonylic photoinitiator and/or certain dyes are additionally added.

7. A radiation-sensitive mixture as claimed in any of claims 1 to 6, wherein precursor (a) is used in a monomeric, oligomeric or polymeric form or in the form of a mixture of different polymerization stages.

8. A radiation-sensitive mixture as claimed in any of claims 1 to 7, wherein precursor (a) is a precursor for a polyimide, for a polyisoindoloquinazolinedione, for a polyoxazinedione or for a polyquinazolinedione.

9. A radiation-sensitive mixture as claimed in any of claims 1 to 8, wherein precursor (a) has been obtained by linking a carboxyl-containing polyaddition product of an aromatic and/or heterocyclic tetracarboxylic anhydride and a diamino compound at the carboxyl groups to radicals R¹ via an ester, ether, amide or urethane group.

10. A radiation-sensitive mixture as claimed in any of claims 1 to 8, wherein precursor (a) has been obtained by linking a carboxyl-containing polyaddition product of an aromatic and/or heterocyclic dihydroxydicarboxylic acid and a diisocyanate at the carboxyl groups to radicals R¹ via an ester, ether, amide or urethane group.

11. A radiation-sensitive mixture as claimed in any of claims 1 to 8, wherein precursor (a) has been obtained by linking a carboxyl-containing polyaddition product of an aromatic and/or heterocyclic diaminodicarboxylic acid and a diisocyanate at the carboxyl groups to radicals R¹ via an ester, ether, amide or urethane group.

12. A process for preparing a radiation-sensitive mixture as claimed in any of the preceding claims, which comprises introducing a radical R¹ into a precursor (a) by reacting a carboxyl-containing polyaddition product of an aromatic and/or heterocyclic diaminodicarboxylic acid and a diisocyanate, and/or a carboxyl-containing polyaddition product of an aromatic and/or heterocyclic dihydroxydicarboxylic acid and diisocyanate, and/or a carboxyl-containing polyaddition product of an aromatic and/or heterocyclic tetracarboxylic anhydride and a diamino compound with a mono adduct of a diisocyanate and a compound of the structure R¹-OH, R¹-NH₂, R¹-B²-NH₂ and/or R¹-COOH.

13. A process as claimed in claim 12, wherein the radicals R¹ are introduced into a carboxyl-containing polyaddition product of an aromatic and/or heterocyclic diaminodicarboxylic acid and a diisocyanate and/or into a carboxyl-containing polyaddition product of an aromatic and/or heterocyclic dihydroxydicarboxylic acid and a diisocyanate and/or into a carboxyl-containing polyaddition product of an aromatic and/or heterocyclic tetracarboxylic anhydride and a diamino compound in such an amount that the ratio of R¹ to carboxyl in the carboxyl-containing polyaddition product is 1:1 to 0.05 to 1.

14. A process as claimed in claim 12 or 13, wherein the tetracarboxylic anhydride used is pyromellitic anhydride and/or benzophenonetetracarboxylic anhydride.

15. A process as claimed in claim 12 or 13, wherein the dihydroxydicarboxylic acid used is 4,4'-dihydroxydiphenylmethane-3,3'-dicarboxylic acid.

16. A process as claimed in claim 12 or 13, wherein the diaminodicarboxylic acid used is 4,4'-diaminodiphenylmethane-3,3'-dicarboxylic acid.

17. A radiation-sensitive mixture as claimed in any of claims 1 to 11, wherein precursor (a) is not exclusively crosslinkable via the radicals R¹ but contains further radiation-sensitive radicals, in particular radicals having ethylenic double bonds and/or other radicals which crosslink with bisazides.

18. A radiation-sensitive mixture as claimed in any of claims 1 to 8, wherein the radical Q of the general formula (I) is derived from 2,3,9,10-perylenetetracarboxylic acid, 1,4,5,8-naphthalenetetracarboxcylic acid, 2,6-dichloronaphthalene-1,4,5,8-tetracarboxylic acid, 2,7-dichloronaphthalene-1,4,5,8-tetracarboxylic acid, phenanthrene-1,8,9,10-tetracarboxylic acid, pyromellitic acid, 3,3',4,4'-biphenyltetracarboxylic acid, 2,2',4,4'-biphenyltetracarboxylic acid, 4,4'-isopropylidenediphthalic acid, 3,3'-propylidenediphthalic acid, 4,4'-oxydiphthalic acid, 4,4'-sulfonyldiphthalic acid, 3,3'-oxydiphthalic acid, dicarboxydihydroxydiphenylmethane isomers, diaminodicarboxydiphenylmethane isomers, dicarboxydihydroxydiphenyl oxide isomers, diaminodicarboxydiphenyl oxide isomers, dicarboxydihydroxydiphenyl sulfone isomers, diaminodicarboxydiphenyl sulfoxide isomers, 4,4'-methylenediphthalic acid, 4,4'-thiodiphthalic acid, 4,4'-acetylidenediphthalic acid, 2,3,6,7-naphthalenetetracarboxylic acid, 1,2,4,5-naphthalenetetracarboxylic acid, 1,2,3,5-naphthalenetetracarboxylic acid, benzene-1,2,3,4-tetracarboxylic acid, thiophene-2,3,4,5-tetracarboxylic acid, 1-(3',4'-dicarboxyphenyl)-1,3,3-trimethylindane-5,6-dicarboxylic acid, 1-(3',4'-dicarboxyphenyl)-1,3,3-trimethylindane-6,7-dicarboxylic acid, pyrazine-2,3,5,6-tetracarboxylic acid, tetrahydrofurantetracarboxylicacid, 9-bromo-10-mercaptoanthracenetetracarboxylic acid, 9,10-dimercaptoanthracenedicarboxylic acid, benzophenonetetracarboxylic acid and also substitution products of these polycarboxylic acids, in particular their halogen and/or alkyl substitution products.

19. A radiation-sensitive mixture as claimed in any of claims 1 to 11 or 17 or 18, wherein precursor (a) has been functionalized not with just one type of radicals R¹ but with a combination of different radicals R¹.

20. A radiation-sensitive mixture as claimed in any of claims 1 to 11 or 17 to 19, wherein the radicals R³ are derived from diaminodicyclohexylmethane, diamino(dimethyl)dicyclohexylmethane, diamino(dimethyldiisopropyl)dicyclohexylmethane, diamino(tetraisopropyl)dicyclohexylmethane, diamino(diisopropyl)dicyclohexylmethane, diisopropyltoluylenediamine, alkylisopropyltoluylenediamine, diaminodiisopropyldiphenylmethane, diaminodiisopropyldiphenyl oxide and/or diaminodiphenylpropane, which are bonded to the main chain of precursor (a) via their amino groups.

21. A radiation-sensitive mixture as claimed in any of claims 1 to 11 or 17 to 19, wherein the radicals R³ are derived from toluylene diisocyanate, isophorone diisocyanate, diisocyanatodiphenylmethane, trimethylhexamethylene diisocyanate, hexamethylene diisocyanate, dicyclohexylmethane diisocyanate, the diners of these isocyanates formed via uretdione groups or monomeric, oligomeric and/or polymeric diisocyanates obtained from the reaction of bifunctional compounds which are reactive with isocyanate groups, such as diamines or diols, with diisocyanates, and are bonded to the main chain of precursor (a).

22. A radiation-sensitive mixture as claimed in any of claims 1 to 11 or 17 to 21, wherein there are in addition present such radicals R² and R¹ as are likewise capable of ready abstraction of hydrogen atoms.

23. A radiation-sensitive mixture as claimed in any of claims 1 to 11 or 17 to 22, wherein the radiation-reactive composition is used mixed with other radiation-sensitive substances and/or non-radiation-sensitive substances.

24. The use of a radiation-sensitive mixture as claimed in any of claims 1 to 11 or 17 to 23 for producing protective and insulating layers for use in the construction of printed and integrated circuits, in which the mixture is subjected to radiative crosslinking and/or thermal aftertreatment.

25. The use of a radiation-sensitive mixture as claimed in any of claims 1 to 11 or 17 to 24 for producing protective and insulating layers for use in the construction of printed and integrated circuits, in which the mixture is exposed under a mask and thereby partially crosslinked, then structured with a suitable solvent and then if necessary subjected to a thermal aftertreatment.

## Revendications

1. Mélange photosensible, convenant à la fabrication de polyimides, de polyisoindoloquinazolinediones, de polyoxazinediones, de polyquinazolinediones ou de polyquinazolones, qui subit une différenciation de solubilité par exposition à de la lumière actinique, caractérisé en ce que le mélange photosensible se compose
(a) d'un ou plusieurs précurseurs qui présentent des éléments de structure de la formule générale (I) 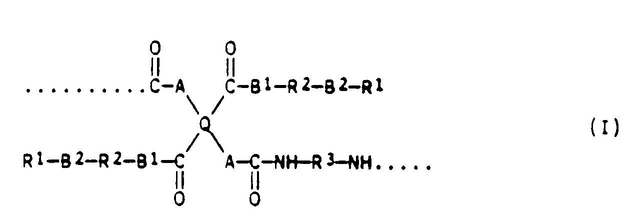 dans laquelle
A représente -O-, -NH- ou une simple liaison,
Q représente un reste hétérocyclique ou aromatique, éventuellement substitué, ou un reste contenant des restes aromatiques bivalents mutuellement liés par l'intermédiaire d'un groupe de pontage, où à chaque fois deux des valences sont agencées l'une par rapport à l'autre en position voisine,
B¹ représente -O- ou -NR⁴,
B² représente -NH-CO-NH-, -NH-CO-O, -NH-CO-, ou une simple liaison,
R¹ représente un atome d'hydrogène, un radical alkyle, aryle, un reste éthyléniquement insaturé ou un reste donnant facilement de l'hydrogène, appartenant aux radicaux isoalkyle, aminoisoalkyle, cycloisoalkyle, cycloisoalkyle avec un ou plusieurs hétéroatomes, isoalkylaryle, ou des groupements choisis parmi ceux répondant aux formules générales suivantes : 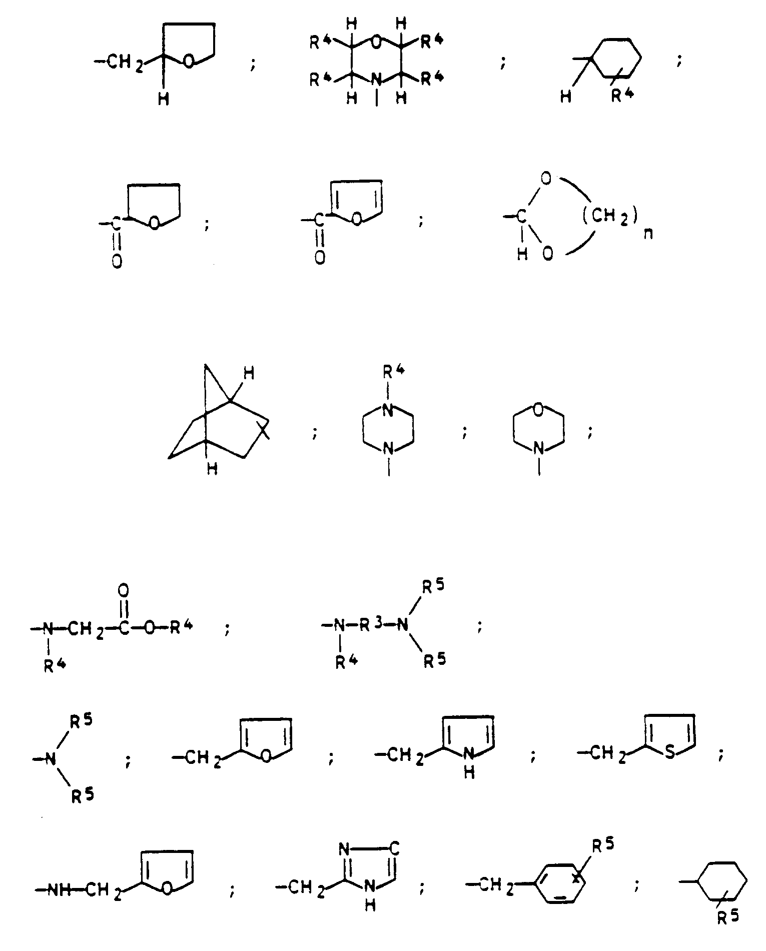
dans lesquelles
n est égal à 2 ou à 3
et
R² représente un reste aromatique ou aliphatique bivalent, ou une simple liaison,
R³ représente un reste hétérocyclique, aromatique, cycloaliphatique ou aliphatique, bivalent, à substitution halogénée éventuelle, ou une simple liaison,
R⁴ représente un atome d'hydrogène, un radical alkyle linéaire ou ramifié, qui peut être substitué par des halogènes et
R⁵ représente un radical alkyle, aryle, alkyle à substitution halogénée, aryle à substitution halogénée, ou isoamylphényle.
avec la condition qu'au moins l'un des restes Q et R³ représentent un radical isoalkyle, méthylcyclohexyle, aminoisoalkyle, furfuryle, tétrahydrofurfuryle, benzyle, cumyle, p-menthyle, terpényle et/ou thymolyle,
(b) d'un ou plusieurs composés carbonylés contenant des restes aromatiques, qui sont susceptibles d'une abstraction d'hydrogène à l'état excité par un rayonnement UV, et éventuellement complémentairement aussi des cétones aliphatiques et des copolymères du monoxyde de carbone avec l'éthylène, seuls ou en combinaison avec les composés carbonylés susmentionnés, comme éventuellement encore
(c) une ou plusieurs substances appartenant au groupe formé par un photoamorceur, un photosensibilisateur, un (leuco)colorant et une cétone aliphatique, où pour tester la photosensibilité de ces mélanges, on étale leurs solutions de résine avec 2% de benzophénone, par rapport à la teneur en résine, sur des plaques de verre, on les sèche à 50°C, sous vide et pendant 3 heures, on recouvre les films non collants d'une épaisseur de 25 à 30 µm, ainsi obtenus, jusqu'à moitié avec une feuille d'aluminium, on les irradie pendant 15 minutes sous une lampe à mercure à haute pression et on en examine ensuite les différences de solubilité entre endroits exposés et recouverts par frottement avec un tampon d'ouate imprégné d'un mélange 1:1 d'éthanol et de N-méthylpyrrolidone.

2. Mélange photosensible suivant la revendication 1, caractérisé en ce qu'à titre de composé carbonylé contenant des restes aromatiques (b), on utilise au moins une cétone aromatique appartenant au groupe formé par la benzophénone, la xanthone, la thioxanthone, la fluorénone, le benzile, l'acénaphtènequinone, la tétralone, la benzylidèneacétone, la dibenzylidèneacétophénone, la benzoïne, l'éther de benzoïne, le benzanilide, l'acétophénone, la propiophénone, la naphtoquinone, l'anthraquinone, l'anthrone, la 2-, 3- et 4-hydroxybenzophénone, l'acide benzophénone-2-carboxylique, l'acide benzophénone-3-carboxylique, l'acide benzophénone-4-carboxylique, l'acide 3,3,4,4'-benzophénonetétracarboxylique et son anhydride, la 3,3',4,4'-tétra(tert-butylperoxycarbonyl)-benzophénone, la 2-, 3- et 4-phénylbenzophénone, des 2-, 3- et 4-alkylbenzophénones dont le radical alkyle comporte de 1 à 10 atomes de carbone, la (monoalkyl)benzophénone halogénée et la 4-(trifluorométhyl)benzophénone.

3. Mélange photosensible suivant l'une quelconque des revendications 1 et 2, caractérisé en ce que, à titre de composés carbonylés (b), on utilise l'hétérodianthrone et son endoperoxyde, ou la 2-acétonaphtone, la 4-aminobenzophénone, la 4,4'-tétraméthylaminobenzophénone et les sels de ces amines, comme éventuellement complémentairement des cétones aliphatiques, telles que l'acétone, la méthylisobutylcétone, l'isoamylcétone et des copolymères du monoxyde de carbone avec l'éthylène, seuls ou en combinaison avec les composés carbonylés cités dans la revendication 2.

4. Mélange photosensible suivant l'une quelconque des revendications 1 à 3, caractérisé en ce que l'on utilise le composé carbonylé (b) en une proportion de 0,01 à 200% en poids, par rapport au précurseur (a).

5. Mélange photosensible suivant l'une quelconque des revendications 1 à 4, caractérisé en ce que l'on emploie les composés carbonylés (b) sous forme solide, dissoute, dispersée ou fondue, monomérique et/polymérique.

6. Mélange photosensible suivant l'une quelconque des revendications 1 à 5, caractérisé en ce qu'en vue de l'amélioration de la sensibilité à la lumière et/ou de l'adaptation de l'absorption en réponse à l'absorption à une source de rayonnement UV, on ajoute complémentairement des photoamorceurs non carbonyliques et/ou des colorants déterminés.

7. Mélange photosensible suivant l'une quelconque des revendications 1 à 6, caractérisé en ce que l'on utilise les précurseurs (a) sous forme monomérique, oligomérique ou polymérique, ou en mélanges à divers stades de polymérisation.

8. Mélange photosensible suivant l'une quelconque des revendications 1 à 7, caractérisé en ce que les précurseurs (a) sont des précurseurs pour des polyimides, des polyisoindoloquinazolinediones, des polyoxazinediones, ou des polyquinazolinediones.

9. Mélange photosensible suivant l'une quelconque des revendications 1 à 8, caractérisé en ce qu'à titre de précurseurs (a), on utilise ceux qui ont été obtenus par le couplage de produits de polyaddition contenant des radicaux carboxyle d'anhydrides d'acides tétracarboxyliques aromatiques et/ou hétérocycliques et de composés du type diamino sur les groupes carboxyle avec des restes R¹ par l'intermédiaire d'un radical ester, éther, amide ou uréthanne.

10. Mélange photosensible suivant l'une quelconque des revendications 1 à 8, caractérisé en ce qu'à titre de précurseurs (a), on utilise ceux qui ont été obtenus par le couplage de produits de polyaddition contenant des radicaux carboxyle d'acides dihydroxydicarboxyliques aromatiques et/ou hétérocycliques et de diisocyanates sur les radicaux carboxyle avec des restes R¹ par l'intermédiaire de radicaux ester, éther, amide ou uréthanne.

11. Mélange photosensible suivant l'une quelconque des revendications 1 à 8, caractérisé en ce que, à titre de précurseurs (a), on utilise ceux qui ont été obtenus par le couplage de produits de polyaddition d'acides diaminodicarboxyliques aromatiques et/ou hétérocycliques et de diisocyanates sur les radicaux carboxyle avec des restes R¹ par l'intermédiaire d'un radical ester, éther, amide ou uréthanne.

12. Procédé de préparation de mélanges photosensibles suivant l'une quelconque des revendications précédentes, caractérisé en ce que, en vue de l'introduction des restes R¹ dans les précurseurs (a), on fait réagir des produits de polyaddition contenant des radicaux carboxyle d'acides diaminodicarboxyliques aromatiques et/ou hétérocycliques et/ou des produits de polyaddition contenant des radicaux carboxyle d'acides dihydroxydicarboxyliques aromatiques et/ou hétérocycliques et/ou des produits de polyaddition contenant des radicaux carboxyle d'anhydrides d'acides tétracarboxyliques aromatiques et/ou hétérocycliques et de composés du type diamino, avec des monoadduits de diisocyanates avec des composés de la structure R¹-OH, R¹-NH₂, R¹-B²-NH₂ et/ou R¹-COOH.

13. Procédé suivant la revendication 12, caractérisé en ce que l'on introduit les restes R¹ dans les produits de polyaddition contenant des radicaux carboxyle d'acides diaminodicarboxyliques aromatiques et/ou hétérocycliques et de diisocyanates et/ou les produits de polyaddition contenant des radicaux carboxyle d'acides dihydroxydicarboxyliques aromatiques et/ou hétérocycliques et de diisocyanates et/ou les produits de polyaddition contenant des radicaux carboxyle d'anhydrides d'acides tétracarboxyliques aromatiques et/ou hétérocycliques et de composés du type diamino, en une proportion telle que le rapport des restes R¹ aux radicaux carboxyle des produits de polyaddition contenant des radicaux carboxyle fluctue de 1:1 à 0,05 à 1.

14. Procédé suivant l'une quelconque des revendications 12 et 13, caractérisé en ce que l'on utilise l'anhydride pyromellitique et/ou l'anhydride benzophénonetétracarboxylique à titre d'anhydride d'acide tétracarboxylique.

15. Procédé suivant l'une quelconque des revendications 12 et 13, caractérisé en ce que l'on utilise l'acide 4,4'-dihydroxydiphénylméthane-3,3'-dicarboxylique à titre d'acide dihydroxydicarboxylique.

16. Procédé suivant l'une quelconque des revendications 12 et 13, caractérisé en ce que l'on utilise l'acide 4,4'-diaminodiphénylméthane-3,3'-dicarboxylique à titre d'acide diaminodicarboxylique.

17. Mélange photosensible suivant l'une quelconque des revendications 1 à 11, caractérisé en ce que les précurseurs (a) ne sont pas exclusivement réticulables par l'intermédiaire des restes R¹, mais qu'ils contiennent d'autres restes photosensibles, plus particulièrement des restes avec des doubles liaisons éthyléniques et/ou des restes avec des bisazides.

18. Mélange photosensible suivant l'une quelconque des revendications 1 à 8, caractérisé en ce que le reste Q de la formule générale (I) dérive de l'acide 2,3,9,10-pérylènetétracarboxylique, de l'acide 1,4,5,8-naphtalènetétracarboxylique, de l'acide 2,7-dichloronaphtalène-1,4,5,8-tétracarboxylique, de l'acide 2,2-dichloronaphtalène-1,4,5,8-tétracarboxylique, de l'acide phénanthrène-1,8,9,10-tétracarboxylique, de l'acide pyromellitique, de l'acide 3,3',4,4'-biphényltétracarboxylique, de l'acide 2,2',4,4'-biphényltétracarboxylique, de l'acide 4,4'-isopropylidènediphtalique, de l'acide 3,3'-propylidènediphtalique, de l'acide 4,4'-oxydiphtalique, de l'acide 4,4'-sulfonyldiphtalique, de l'acide 3,3'-oxydiphtalique, de dicarboxyhydroxydiphénylméthanes isomères, de diaminodicarboxydiphénylméthanes isomères, de l'oxyde de dicarboxydihydroxydiphényle isomères, de l'oxyde de diaminodicarboxydiphényle isomères, de dicarboxydihydroxydiphénylsulfones isomères, de sulfoxydes de diaminodicarboxydiphényle isomères, de l'acide 4,4'-méthylènediphtalique, de l'acide 4,4'-thiodiphtalique, de l'acide 4,4'-acétylidènediphtalique, de l'acide 2,3,6,7-naphtalènetétracarboxylique, de l'acide 1,2,4,5-naphtalènetétracarboxylique, de l'acide 1,2,3,5-naphtalènetétracarboxylique, de l'acide benzène-1,2,3,4-tétracarboxylique, de l'acide thiophène-2,3,4,5-tétracarboxylique, de l'acide 1-(3',4'-dicarboxyphényl)-1,3,3-triméthylindane-5,6-dicarboxylique, de l'acide 1-(3',4'-dicarboxyphényl)-1,3,3-triméthylindane-6,7-dicarboxylique, de l'acide pyrazine-2,3,5,6-tétracarboxylique, de l'acide tétrahydrofurannetétracarboxylique, de l'acide 9-bromo-10-mercaptoanthracènetétracarboxylique, de l'acide 9,10-dimercaptoanthracènedicarboxylique, l'acide benzophénonetétracarboxylique, comme aussi de produits de substitution de ces acides polycarboxyliques, plus particulièrement leurs produits de substitution halogénée et/alkylique.

19. Mélange photosensible suivant l'une quelconque des revendications 1 à 11 ou 17 à 18, caractérisé en ce que les précurseurs (a) ne sont pas seulement fonctionnalisés avec une seule sorte de restes R¹, mais bien aussi avec des combinaisons de différents restes R¹.

20. Mélange photosensible suivant l'une quelconque des revendications 1 à 11 ou 17 à 19, caractérisé en ce que les restes R³ dérivent du diaminodicyclohexylméthane, du diamino-(diméthyl)-dicyclohexylméthane, du diamino(diméthyl-diisopropyl)-dicyclohexylméthane, du diamino(tétraisopropyl)-dicyclohexylméthane, du diamino-(diisopropyl)-dicyclohexylméthane, de la diisopropyltoluylènediamine, d'alkyl-isopropyl-toluylènediamines, du diaminodiisopropyldiphénylméthane, de l'oxyde de diaminodiisopropyldiphényle et/ou du diaminodiphénylpropane, qui sont liés par leurs radicaux amino à la chaîne principale du précurseur (a).

21. Mélange photosensible suivant l'une quelconque des revendications 1 à 11 ou 17 à 19, caractérisé en ce que les restes R³ dérivent du diisocyanate de toluylène, du diisocyanate d'isophorone, du diisocyanatodiphénylméthane, du diisocyanate de triméthylhexaméthylène, du diisocyanate d'hexaméthylène, du diisocyanate de dicyclohexylméthane, de dimères de ces isocyanates formés par l'intermédiaire de radicaux uretdione, ou de diisocyanates monomériques, oligomériques et/ou polymériques, obtenus par la réaction de composés bifonctionnels réactifs avec des radicaux isocyanate, comme des diamines ou des diols, avec des diisocyanates et sont liés à la chaîne principale du précurseur (a).

22. Mélange photosensible suivant l'une quelconque des revendications 1 à 11 ou 17 à 21, caractérisé en ce que sont complémentairement contenus des restes R² et R¹ du genre de ceux qui sont également susceptibles d'une abstraction aisée d'atomes d'hydrogène.

23. Mélange photosensible suivant l'une quelconque des revendications 1 à 11 ou 17 à 22, caractérisé en ce que les masses photoréactives s'utilisent avec d'autres substances photosensibles et/ou des substances non photosensibles.

24. Utilisation des mélanges photosensibles suivant l'une quelconque des revendications 1 à 11 ou 17 à 23, en vue de l'obtention de couches protectrices et isolantes à employer pour la fabrication de circuits imprimés et/ou de circuits de commutation intégrés, où ils sont soumis à une photoréticulation et/ou un posttraitement thermique.

25. Utilisation des mélanges photosensibles suivant l'une quelconque des revendications 1 à 11 ou 17 à 24 pour l'obtention de couches protectrices et isolantes à employer pour la construction de circuits imprimés et de circuits de commutation intégrés, où ils sont exposés sous un masque et de ce fait partiellement photoréticulés, puis sont structurés à l'aide de solvants appropriés et sont ensuite éventuellement soumis à un posttraitement thermique.
